# EUROPEAN PATENT APPLICATION

(11) **EP 4 770 366 A1**
(43) Date of publication of application: **01.07.2026**
(21) Application number: 25227347.9
(22) Date of filing: 29.12.2025
(51) Int. Cl.: H10K 59/121, H10K 59/124, H10K 59/80, H10K 101/10

(54) **DISPLAY DEVICE AND ELECTRONIC DEVICE INCLUDING THE SAME**

(30) Priority: 30.12.2024 KR 20240199944
(71) Applicant: Samsung Display Co., Ltd., Yongin-si, Gyeonggi-do 17113 (KR)
(72) Inventor: Lee, Hyeon Bum, Yongin-si, Gyeonggi-do (KR); Kwak, Eun Jin, Yongin-si, Gyeonggi-do (KR); Kim, Gee Bum, Yongin-si, Gyeonggi-do (KR); Kim, Dong Uk, Yongin-si, Gyeonggi-do (KR); Kim, Soo Youn, Yongin-si, Gyeonggi-do (KR); Kim, Hyun Ho, Yongin-si, Gyeonggi-do (KR); Kim, Hyoeng Ki, Yongin-si, Gyeonggi-do (KR); Shim, Dong Hwan, Yongin-si, Gyeonggi-do (KR); Lee, Sung Eun, Yongin-si, Gyeonggi-do (KR); Lee, Eon Joo, Yongin-si, Gyeonggi-do (KR); Lee, Hoon Gi, Yongin-si, Gyeonggi-do (KR)
(74) Representative: Gulde & Partner

(57) **Abstract**

A display device (10) according to the present disclosure includes a substrate (110), a transistor (TR) on a surface of the substrate (110), an under-anode insulating layer (129) disposed on the transistor (TR) and including first and second portions (131a, 131b) having different thicknesses (t) from each other and a third portion connecting the first and second portions (131a, 131b), a pixel electrode (131) on the first portion (131a), the second portion (131b), and the third portion, a pixel defining layer (135) on the pixel electrode (131) and the under-anode insulating layer (129), a light-emitting layer (132) on the pixel electrode (131), and a common electrode (133) on the light-emitting layer (132) and the pixel defining layer (135). The under-anode insulating layer (129) includes a first under-anode insulating layer (1291) including a first hole (H1) in the first portion (131a) , and a second under-anode insulating layer (1292) defining or including at least a portion within the first hole (H1) and corresponding to or contacting the first portion (131a). The first under-anode insulating layer (1291) includes an inorganic material, and the second under-anode insulating layer (1292) includes an organic material.

## Description

### BACKGROUND

### 1. Field

The disclosure relates to a display device and an electronic device including the same.

### 2. Description of the Related Art

With the development of communications technology and media, display devices are being used to display images in various places and environments. In particular, various types of display devices such as liquid crystal displays and organic light-emitting displays are being widely used.

Organic light-emitting displays are widely used in display devices due to their relatively fast response speed, relatively high luminance and wide viewing angle, and relatively low power consumption.

### SUMMARY

However, when a display device is viewed from the side, the luminance of the display device may be lower than when the display device is viewed from the front. In addition, due to a difference in refractive index according to the color displayed by the display device, the color of the display device may be distorted when the display device is viewed from the side compared to when the display device is viewed from the front. As a result, even when the display device displays a white image, the image of the display device may look somewhat blue when viewed from the side compared to when viewed from the front.

Features of the disclosure provide a display device with improved luminance and chrominance when viewed from the side compared to when viewed from the front and an electronic device including the display device.

Features of the disclosure also provide a display device with minimized mura and an electronic device including the display device.

However, features of the disclosure are not restricted to the one set forth herein. The above and other features of the disclosure will become more apparent to one of ordinary skill in the art to which the disclosure pertains by referencing the detailed description of the disclosure given below.

According to a feature of the disclosure, there is provided a display device including a substrate, a transistor disposed on a surface of the substrate, an under-anode insulating layer disposed on the transistor and including a first portion and a second portion having different thicknesses from each other and a third portion connecting the first portion and the second portion, a pixel electrode disposed on the first portion, the second portion, and the third portion, a pixel defining layer disposed on the pixel electrode and the under-anode insulating layer and including an opening which overlaps the first portion, the second portion and the third portion, a light-emitting layer disposed on the pixel electrode, and a common electrode disposed on the light-emitting layer and the pixel defining layer, wherein the under-anode insulating layer includes a first under-anode insulating layer defining or including a first hole in the first portion, and a second under-anode insulating layer having at least a portion within the first hole and corresponding to or contacting the first portion, wherein the first under-anode insulating layer includes an inorganic material, and the second under-anode insulating layer includes an organic material.

In an embodiment, an upper surface of the pixel electrode may comprise a first upper surface portion overlapping the first portion, may comprise a second upper surface portion overlapping the second portion and may comprise a third upper surface portion overlapping the third portion, angles between tangent lines touching the third upper surface portion and the surface of the substrate may be equal to or greater than a first angle, and angles between tangent lines touching the first upper surface portion and the surface of the substrate and angles between tangent lines touching the second upper surface portion and the surface of the substrate may be less than the first angle.

In an embodiment, the first angle may be 3 degrees.

In an embodiment, the first portion and the second portion may be flat portions, and the third portion may be an inclined portion.

In an embodiment, when an intersection of the first upper surface portion and the third upper surface portion is defined as a first point, an intersection of the second upper surface portion and the third upper surface portion is defined as a second point, an imaginary extension line extending parallel to the surface of the substrate from the first point toward an opposite side from the first upper surface portion is defined as a first extension line, and a line connecting the first point and the second point is defined as a first inclined line, a first inclination angle defined by the first inclined line and the first extension line may be 20 degrees or more.

In an embodiment, the first inclination angle may be 35 degrees or less.

In an embodiment, a thickness of the under-anode insulating layer in the second portion may be 2 micrometers (µm) or more.

In an embodiment, the display device may further comprise a source-drain conductive layer disposed between the transistor and the under-anode insulating layer and comprising one or more under-anode conductive patterns, wherein the source-drain conductive layer may comprise a first conductive pattern closest to the pixel electrode in a thickness direction of the substrate among the one or more under-anode conductive patterns, and a distance between the first conductive pattern and the pixel electrode may be 2 µm or more.

In an embodiment, the first under-anode insulating layer may contact the pixel electrode in the second portion and the third portion, and the second under-anode insulating layer may contact the pixel electrode in the first portion.

In an embodiment, the second under-anode insulating layer may be disposed only within the first hole.

In an embodiment, a thickness of the second under-anode insulating layer in the first portion may be 1 µm or less.

In an embodiment, the first under-anode insulating layer may further comprise a first inclined surface overlapping the third portion and an upper surface connected to the first inclined surface, an upper surface of the second under-anode insulating layer may directly contact the pixel electrode in the first portion, the second portion and the third portion, and a lower surface of the second under-anode insulating layer may directly contact the first inclined surface and the upper surface of the first under-anode insulating layer.

In an embodiment, the upper surface of the second portion may comprise a curved surface.

In an embodiment, the thickness of the second under-anode insulating layer in the first portion may be 1 µm or less.

In an embodiment, the display device may further comprise a color filter layer disposed on the common electrode.

According to a feature of the disclosure, there is provided a display device including, a substrate, a transistor disposed on a surface of the substrate, an under-anode insulating layer disposed on the transistor and including a groove, a first portion overlapping the groove, and a second portion having a different thickness from a thickness of the first portion, a pixel electrode disposed on the first portion and the second portion, a pixel defining layer disposed on the pixel electrode and the under-anode insulating layer and including an opening which overlaps the first portion and the second portion, a light-emitting layer disposed on the pixel electrode, and a common electrode disposed on the light-emitting layer and the pixel defining layer, wherein the under-anode insulating layer includes an inorganic material.

In an embodiment, an upper surface of the pixel electrode may comprise a first upper surface portion overlapping the first portion and a second upper surface portion overlapping the second portion, angles between tangent lines touching the first upper surface portion and the surface of the substrate may be equal to or greater than a first angle, and angles between tangent lines touching the second upper surface portion and the surface of the substrate may be less than the first angle.

In an embodiment, the first angle may be 3 degrees.

In an embodiment, the first portion may be an inclined portion, and the second portion may be a flat portion.

In an embodiment, the first upper surface portion may comprise a first sub-portion and a second sub-portion directly connected to each other and extending in different directions in a cross section taken in a thickness direction of the substrate, and when an intersection of the first sub-portion and the second sub-portion is defined as a first point, an intersection of the first upper surface portion and the second upper surface portion is defined as a second point, a line connecting the first point and the second point is defined as a first inclined line, and an imaginary extension line extending parallel to the surface of the substrate in a direction overlapping the first inclined line from the first point is defined as a first extension line, a first inclination angle defined by the first inclined line and the first extension line may be 20 degrees or more.

In an embodiment, the first inclination angle may be 35 degrees or less.

In an embodiment, in the thickness direction of the substrate, a thickness of the under-anode insulating layer in an area overlapping the first point may be 1 µm or less.

In an embodiment, the thickness of the under-anode insulating layer in the second portion may be 2 µm or more.

In an embodiment, the display device may further comprise a source-drain conductive layer disposed between the transistor and the under-anode insulating layer and comprising one or more under-anode conductive patterns, wherein the source-drain conductive layer may comprise a first conductive pattern closest to the pixel electrode in a thickness direction of the substrate among the one or more under-anode conductive patterns, and a distance between the first conductive pattern and the pixel electrode may be 2 µm or more.

In an embodiment, the display device may further comprise a color filter layer disposed on the common electrode.

According to a feature of the disclosure, there is provided an electronic device including, a display device, a cover window disposed on the display device, a bottom cover disposed under the display device, and a main circuit board disposed between the display device and the bottom cover, wherein the display device includes a substrate, a transistor disposed on a surface of the substrate, an under-anode insulating layer disposed on the transistor and including a first portion and a second portion having different thicknesses from each other and a third portion connecting the first portion and the second portion, a pixel electrode disposed on the first portion, the second portion, and the third portion, a pixel defining layer disposed on the pixel electrode and the under-anode insulating layer and including an opening which overlaps the first portion, the second portion and the third portion, a light-emitting layer disposed on the pixel electrode, and a common electrode disposed on the light-emitting layer and the pixel defining layer, wherein the under-anode insulating layer includes a first under-anode insulating layer defining a first hole in the first portion, and a second under-anode insulating layer including at least a portion within the first hole and contacting the first portion, wherein the first under-anode insulating layer includes an inorganic material, and the second under-anode insulating layer includes an organic material.

According to a feature of the disclosure, there is provided an electronic device including, a display device, a cover window disposed on the display device, a bottom cover disposed under the display device, and a main circuit board disposed between the display device and the bottom cover, wherein the display device includes a substrate, a transistor disposed on a surface of the substrate, an under-anode insulating layer disposed on the transistor and including a groove, a first portion overlapping the groove, and a second portion having a different thickness from a thickness of the first portion, a pixel electrode disposed on the first portion and the second portion, a pixel defining layer disposed on the pixel electrode and the under-anode insulating layer and including an opening which overlaps the first portion and the second portion, a light-emitting layer disposed on the pixel electrode, and a common electrode disposed on the light-emitting layer and the pixel defining layer, wherein the under-anode insulating layer includes an inorganic material.

According to a display device and an electronic device including the same according to the disclosure, luminance and chrominance when viewed from the side compared to when viewed from the front may be improved.

According to a display device and an electronic device including the same according to the disclosure, the occurrence of mura may be minimized.

However, the effects of the disclosure are not restricted to the one set forth herein. The above and other effects of the disclosure will become more apparent to one of daily skill in the art to which the disclosure pertains by referencing the claims.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

These and/or other features will become apparent and more readily appreciated from the following description of the embodiments, taken in conjunction with the accompanying drawings in which:
FIG. 1 is a perspective view of an embodiment of an electronic device;
FIG. 2 is an exploded perspective view of the electronic device of FIG. 1;
FIG. 3 is a plan view of a display device of FIG. 2;
FIG. 4 is a cross-sectional view taken along line X1-X1' of FIG. 3;
FIG. 5 is an enlarged view of area A of FIG. 3;
FIG. 6 is an enlarged plan view of an embodiment of a pixel electrode of a first emission area in FIG. 5;
FIG. 7A is a circuit diagram of an embodiment of a pixel circuit of a display device;
FIG. 7B is a cross-sectional view taken along line X2-X2' of FIG. 6;
FIG. 8 is an enlarged view of area B of FIG. 7B;
FIG. 9 is a photograph of a reflection diffraction pattern of a display device according to a comparative example;
FIG. 10 is a photograph of an embodiment of a reflection diffraction pattern of the display device;
FIG. 11 is an enlarged plan view of an embodiment of a pixel electrode of a first emission area of a display device;
FIG. 12 is a cross-sectional view taken along line X3-X3' of FIG. 11;
FIG. 13 is an enlarged plan view of an embodiment of a pixel electrode of a first emission area of a display device;
FIG. 14 is a cross-sectional view taken along line X4-X4' of FIG. 13; and
FIG. 15 is a schematic diagram for explaining a method of defining the slope of a third inclined portion.

### DETAILED DESCRIPTION

The disclosure will now be described more fully hereinafter with reference to the accompanying drawings, in which preferred embodiments of the disclosure are shown. This disclosure may, however, be embodied in different forms and should not be construed as limited to the embodiments set forth herein. Rather, these embodiments are provided so that this disclosure will be thorough and complete, and will filly convey the scope of the disclosure as defined by the appended claims to those skilled in the art.

It will also be understood that when a layer is referred to as being "on" another layer or substrate, it may be directly on the other layer or substrate, or intervening layers may also be present. The same reference numbers indicate the same components throughout the specification.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, the singular forms "a," "an," and "the" are intended to include the plural forms, including "at least one," unless the content clearly indicates otherwise. "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," may therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" may, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term such as "about" may mean within one or more standard deviations, or within ± 30%, 20%, 10%, 5% of the stated value, for example.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Hereinafter, embodiments of the disclosure will be described in detail with reference to the accompanying drawings.

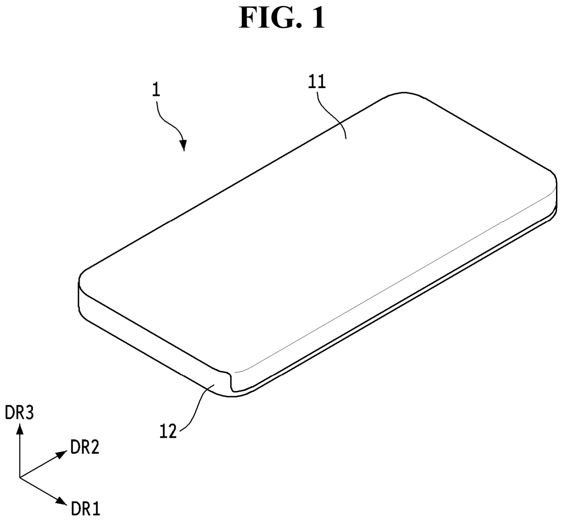

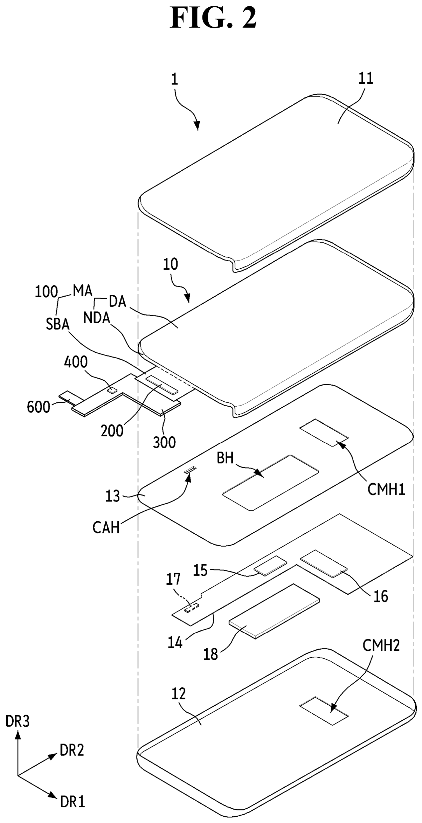

FIG. 1 is a perspective view of an embodiment of an electronic device 1. FIG. 2 is an exploded perspective view of the electronic device 1 of FIG. 1.

Referring to FIGS. 1 and 2, the electronic device 1 in the embodiment is a device having a function of displaying an image in a display area. The electronic device 1 may be portable. In an embodiment, the electronic device 1 may be a portable electronic device such as a mobile phone, a smartphone, a tablet personal computer ("PC"), a smart watch, a watch phone, a mobile communication terminal, an electronic notebook, an electronic book, a portable multimedia player ("PMP"), a navigation device, or an ultra-mobile PC ("UMPC"), for example.

However, the electronic device 1 in the embodiment is not limited to a portable electronic device and may also be a large-sized device such as a television, a notebook computer, a monitor, a billboard, or an Internet of things ("IoT") device.

The electronic device 1 in the embodiment may be utilized throughout electronic devices 1 that use light-emitting elements and may be applied to other various electronic devices 1, e.g., display devices, lighting devices, sensor systems, wearable devices, and including light-emitting elements. However, the disclosure is not limited thereto and may be implemented in all electronic devices 1 that may utilize light-emitting elements.

The electronic device 1 in the embodiment may include a display device 10 and a cover window 11 and a bottom cover 12 provided as a housing to protect the display device 10. The electronic device 1 may further include a bracket 13 disposed under the display device 10 and a main circuit board 14.

The electronic device 1 may have a shape close to a rectangle in a plan view. In an embodiment, the electronic device 1 may have a quadrangular planar shape, e.g., rectangular planar shape having short sides in a first direction DR1 and long sides in a second direction DR2, for example. Each corner where a short side extending in the first direction DR1 meets a long side extending in the second direction DR2 may be rounded to have a selected curvature or may be right-angled. The planar shape of the electronic device 1 is not limited to the quadrangular shape, e.g., rectangular shape but may also be other polygonal shapes, a circular shape, or an elliptical shape.

In the drawings, the first direction DR1 and the second direction DR2 are horizontal directions intersecting each other. In an embodiment, the first direction DR1 and the second direction DR2 may be orthogonal to each other, for example. In addition, a third direction DR3 may intersect the first direction DR1 and the second direction DR2, e.g., may be a vertical direction orthogonal to the first direction DR1 and the second direction DR2. Unless otherwise defined, in the specification, a direction indicated by an arrow of each of the first through third directions DR1 through DR3 may be also referred to as one side, and the opposite direction may be also referred to as an opposite (the other) side. In addition, in the specification, "on", "upper side", "upper", "top", and "upper surface" refer to a direction in which the arrow of the third direction DR3 points in the drawings, and "under", "lower side", "lower", "bottom", and "lower surface" refer to a direction opposite to the direction in which the arrow of the third direction DR3 points in the drawings.

The cover window 11 may be disposed on the display device 10 to cover an upper surface of the display device 10. The cover window 11 may serve to protect the upper surface of the display device 10.

The cover window 11 may include a light-transmitting portion which is transparent and a light-blocking portion which is opaque. The light-transmitting portion may overlap a display area DA of the display device 10 in the third direction DR3, and the light-blocking portion may overlap a non-display area NDA of the display device 10 in the third direction DR3.

The cover window 11 may include an upper surface portion that forms an upper surface of the electronic device 1, a left side surface portion that forms a left side surface of the electronic device 1, and a right side surface portion that forms a right side surface of the electronic device 1. The left side surface portion of the cover window 11 may extend from a left side of the upper surface portion, and the right side surface portion may extend from a right side of the upper surface portion.

Each of the upper surface portion, the left side surface portion, and the right side surface portion of the cover window 11 may include a light-transmitting portion and a light-blocking portion. The light-transmitting portion of the cover window 11 may be disposed in most of each of the upper surface portion, the left side surface portion, and the right side surface portion of the cover window 11. The light-blocking portion of the cover window 11 may be disposed at an upper edge and a lower edge of the upper surface portion of the cover window 11, at an upper edge, a left edge and a lower edge of the left side surface portion of the cover window 11, and at an upper edge, a right edge and a lower edge of the right side surface portion of the cover window 11.

However, the disclosure is not limited thereto, and the side surface portions of the cover window 11 may be omitted depending on the shape of the display device 10. In an embodiment, depending on the position and shape of a display surface of the display device 10, the cover window 11 may include the upper surface portion, for example, but may not include the side surface portions. In an alternative embodiment, the cover window 11 may include an upper side surface portion or a lower side surface portion, regardless of whether it includes the left side surface portion and the right side surface portion.

The display device 10 may be disposed under the cover window 11. That is, the cover window 11 may be disposed on the display device 10.

The display device 10 may include an upper surface portion facing the upper surface portion of the cover window 11, a left side surface portion facing the left side surface portion of the cover window 11, and a right side surface portion facing the right side surface portion of the cover window 11. The left side surface portion of the display device 10 may extend from a left side of the upper surface portion, and the right side surface portion may extend from a right side of the upper surface portion.

The display device 10 may include a display panel 100. The display panel 100 may include a main area MA including a display area DA in which image display is implemented and a non-display area NDA disposed around the display area DA and a sub-area SBA protruding from a side of the main area MA.

The display area DA may be disposed in most of the main area MA. The display area DA may be disposed in the center of the main area MA. In other words, each of the upper surface portion, the left side surface portion, and the right side surface of the display device 10 may include the display area DA and the non-display area NDA. The display area DA may be disposed in most of each of the upper surface portion, the left side surface portion, and the right side surface portion of the display device 10.

However, the disclosure is not limited thereto, and the display area DA may also be disposed only in the upper surface portion of the display device 10 or may be additionally disposed in an upper side surface portion and a lower side surface portion of the display device 10.

The non-display area NDA may be disposed outside the display area DA. The non-display area NDA may be an edge area of the main area MA. The non-display area NDA may be disposed at an upper edge and a lower edge of the upper surface portion of the display device 10, at an upper edge, a left edge and a lower edge of the left side surface portion of the display device 10, and at an upper edge, a right edge and a lower edge of the right side surface portion of the display device 10.

The sub-area SBA may protrude from a side of the main area MA in the second direction DR2. A length of the sub-area SBA in the first direction DR1 may be equal to or smaller than a length of the main area MA in the first direction DR1. A length of the sub-area SBA in the second direction DR2 may be smaller than a length of the main area MA in the second direction DR2, but the disclosure is not limited thereto. As a part of the sub-area SBA is changed into a bent shape, a remaining (the other) part of the sub-area SBA may be overlapped by the main area MA in the third direction DR3.

The display device 10 may further include a display driving circuit 200 disposed on the sub-area SBA of the display panel 100, a display circuit board 300 bonded to a side of the sub-area SBA, a touch driving circuit 400 disposed (e.g., mounted) on the display circuit board 300, and a connector 600 extending from a side of the display circuit board 300.

An end of the display circuit board 300 may be attached onto pads disposed on a lower edge of the sub-area SBA of the display device 10 using an anisotropic conductive film.

The display circuit board 300 may be a flexible printed circuit board that may be bent, a rigid printed circuit board that maintains a flat shape, or a composite printed circuit board including both a rigid printed circuit board and a flexible printed circuit board.

The display driving circuit 200 may transmit data signals of light-emitting pixel drivers of the display area DA to data lines based on control signals, powers and voltages supplied through the display circuit board 300.

The display driving circuit 200 may be provided as an integrated circuit and may be disposed (e.g., mounted) on the sub-area SBA of the display device 10 using a chip on glass ("COG") method or a chip on plastic ("COP") method. However, this is merely one of embodiments, and the disclosure is not limited thereto. In an embodiment, the display driving circuit 200 may also be disposed (e.g., mounted) on the display circuit board 300, for example.

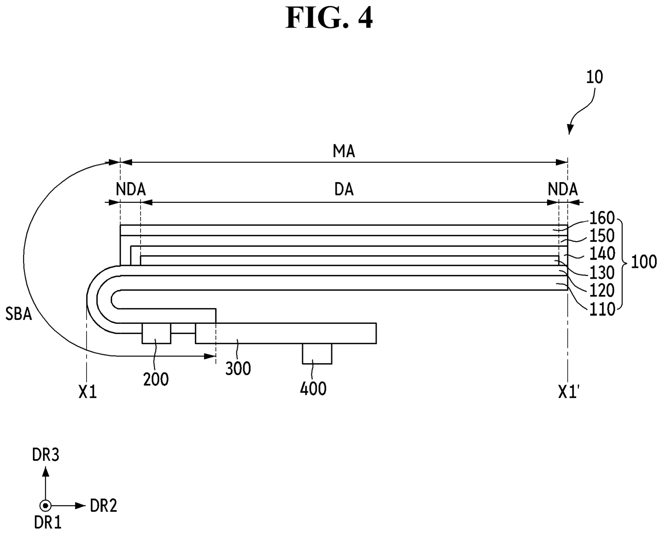

In an embodiment, the touch driving circuit 400 may be disposed on the sub-area SBA of the display device 10. In an alternative embodiment, as illustrated in FIG. 2, the touch driving circuit 400 may be disposed (e.g., mounted) on the display circuit board 300. The touch driving circuit 400 may be electrically connected to a touch sensor layer 150 (refer to FIG. 4) of the display device 10.

The bracket 13 may be disposed under the display device 10. The bracket 13 may include plastic or metal. The bracket 13 may define a first camera hole CMH1 into which a camera device 16 is inserted, a battery hole BH in which a battery 18 is disposed, and a cable hole CAH through which the connector 600 connected to the display circuit board 300 passes.

The main circuit board 14 and the battery 18 may be disposed under the bracket 13.

The main circuit board 14 may be a printed circuit board or a flexible printed circuit board. The main circuit board 14 may include a main processor 15, the camera device 16, and a main connector 17. The main processor 15 may be formed as an integrated circuit.

The camera device 16 may be disposed on both an upper surface and a lower surface of the main circuit board 14. The main processor 15 may be disposed on the upper surface of the main circuit board 14, and the main connector 17 may be disposed on the lower surface of the main circuit board 14.

The main processor 15 may control all functions of the electronic device 1. In an embodiment, the main processor 15 may output digital video data to the display driving circuit 200 through the display circuit board 300 so that the display device 10 may display an image, for example. In addition, the main processor 15 may receive touch data including coordinates of a user's touch from the touch driving circuit 400, determine whether the user has touched or is in proximity, and then perform an operation corresponding to the user's touch input or proximity input. In an embodiment, the main processor 15 may execute an application or perform an operation indicated by an icon touched by the user, for example.

The main processor 15 may be an application processor, a central processing unit, or a system chip formed as an integrated circuit.

The camera device 16 processes an image frame such as a still image or a moving image obtained by an image sensor in a camera mode and outputs the processed image frame to the main processor 15.

The connector 600 passing through the cable hole CAH of the bracket 13 may be connected to the main connector 17. Accordingly, the main circuit board 14 may be electrically connected to the display circuit board 300.

The battery 18 may not overlap the main circuit board 14 in the third direction DR3. The battery 18 may overlap the battery hole BH of the bracket 13 in the third direction DR3.

In addition, the main circuit board 14 may further include a mobile communication module that may transmit and receive wireless signals to and from at least one of a base station, an external terminal, and a server over a mobile communication network. The wireless signals may include voice signals, video call signals, or various types of data resulting from transmission/reception of text/multimedia messages.

The bottom cover 12 may be disposed under the main circuit board 14 and the battery 18. The bottom cover 12 may be fastened and fixed to the bracket 13. The bottom cover 12 may form an upper side surface, a lower side surface, and a lower surface of the electronic device 1. The bottom cover 12 may include plastic, metal, or both plastic and metal.

The bottom cover 12 may define a second camera hole CMH2 exposing a lower surface of the camera device 16. However, the position of the camera device 16 and the positions of the first camera hole CMH1 and the second camera hole CMH2 corresponding to the camera device 16 are not limited to those illustrated in FIG. 2.

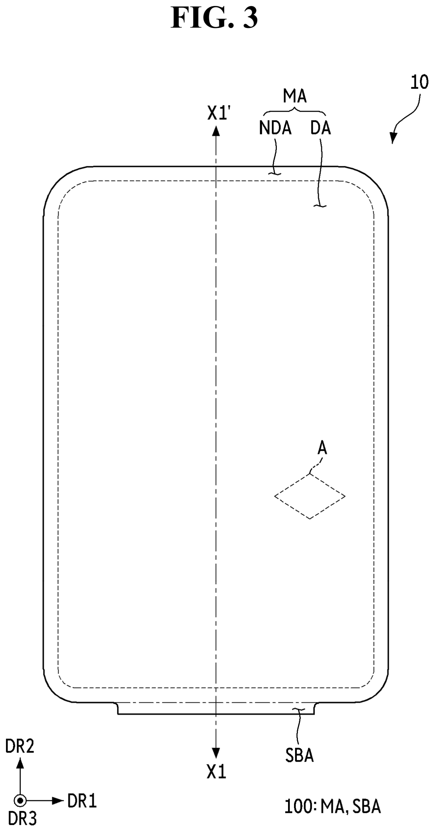

FIG. 3 is a plan view of the display device 10 of FIG. 2. FIG. 4 is a cross-sectional view taken along line X1-X1' of FIG. 3.

Referring to FIGS. 3 and 4, the display device 10 is a device for displaying moving images or still images. The display device 10 may be used as a display screen in portable electronic devices such as mobile phones, smartphones, tablet PCs, smart watches, watch phones, mobile communication terminals, electronic notebooks, electronic books, PMPs, navigation devices and UMPCs, as well as in various products such as televisions, notebook computers, monitors, billboards, and IoT devices.

The display device 10 may be a light-emitting display device such as an organic light-emitting display device using an organic light-emitting diode, a quantum dot light-emitting display device including a quantum dot light-emitting layer, an inorganic light-emitting display device including an inorganic semiconductor, or a micro- or nano-light-emitting display device using a micro- or nano-light-emitting diode. A case where the display device 10 is an organic light-emitting display device will be mainly described below. However, the disclosure is not limited thereto and is also applicable to display devices including an organic insulating material, an organic light-emitting material, and a metal material.

The display device 10 may be formed flat, but the disclosure is not limited thereto. In an embodiment, the display device 10 may include a curved portion formed at left and right ends and having a constant or varying curvature, for example. In addition, the display device 10 may be flexible so that it may be curved, bent, folded, or rolled.

The display area DA may be shaped like a quadrangular plane, e.g., rectangular plane having short sides in the first direction DR1 and long sides in the second direction DR2 intersecting the first direction DR1. Each corner where a short side extending in the first direction DR1 meets a long side extending in the second direction DR2 may be rounded to have a selected curvature or may be right-angled. The planar shape of the display area DA is not limited to a quadrangular shape but may also be other polygonal shapes, a circular shape, or an elliptical shape.

The display device 10 may include the display panel 100. The display panel 100 includes the main area MA and the sub-area SBA disposed on a side of the main area MA.

The main area MA may include the display area DA and the non-display area NDA. The display area DA may be disposed in most of the main area MA. The display area DA may be disposed in the center of the main area MA. The non-display area NDA may be disposed outside the display area DA. The non-display area NDA may be an edge area of the main area MA.

The sub-area SBA may protrude in the second direction DR2 from at least a portion of a side of the main area MA. As a part of the sub-area SBA is changed into a bent shape, a remaining (the other) part of the sub-area SBA may be disposed on a back surface of the display device 10.

In an embodiment, the display device 10 may include a substrate 110, a circuit layer 120 disposed on the substrate 110, an element layer 130 disposed on the circuit layer 120, a sealing layer 140 disposed on the element layer 130, and a touch sensor layer 150 disposed on the sealing layer 140. The display device 10 may further include a color filter layer 160 disposed on the touch sensor layer 150 to reduce reflection of external light.

The substrate 110 may include an insulating material such as polymer resin. In an embodiment, the substrate 110 may include polyimide, for example. The substrate 110 may be a flexible substrate that may be bent, folded, rolled, etc. In an alternative embodiment, the substrate 110 may include an insulating material such as glass. In an embodiment, the substrate 110 may have a stacked structure of a plurality of polyimides and inorganic layers.

The circuit layer 120 may include light-emitting pixel drivers electrically connected to light-emitting elements, at least one constant voltage line which transmits at least one constant voltage to the light-emitting pixel drivers, and data lines which transmit data signals to the light-emitting pixel drivers.

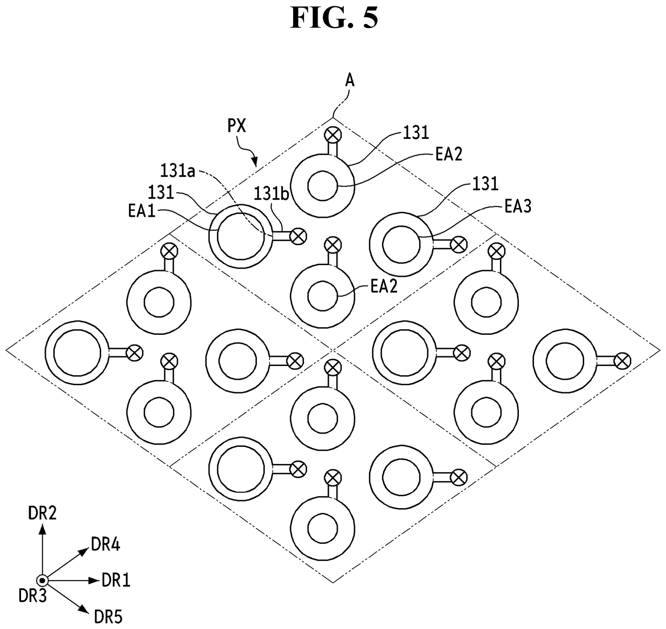

The element layer 130 may include light-emitting elements disposed in emission areas EA1 through EA3 (refer to FIG. 5), respectively.

The sealing layer 140 may cover the element layer 130. The sealing layer 140 may include a structure in which two or more inorganic layers and at least one organic layer are alternately stacked.

The touch sensor layer 150 may be disposed on the sealing layer 140 and may be disposed in the main area MA. The touch sensor layer 150 may include touch electrodes for detecting a touch of a person or an object.

The color filter layer 160 blocks external light reflected from the touch sensor layer 150, the sealing layer 140, the element layer 130, the circuit layer 120 and interfaces thereof to prevent a reduction in image visibility due to reflection of the external light.

As a part of the sub-area SBA is changed into a bent shape, the display driving circuit 200 disposed (e.g., mounted) on the sub-area SBA, the display circuit board 300 connected to a side of the sub-area SBA, and the touch driving circuit 400 disposed (e.g., mounted) on the display circuit board 300 may be placed under the substrate 110.

The display driving circuit 200 may be electrically connected to the data lines of the circuit layer 120. The display driving circuit 200 may transmit data signals to the light-emitting pixel drivers through the data lines based on control signals and power voltages supplied from the display circuit board 300.

The display driving circuit 200 may be provided as an integrated circuit and may be disposed (e.g., mounted) on the sub-area SBA of the display device 10 using a COG method, a COP method, or an ultrasonic method. However, this is merely one of embodiments, and the disclosure is not limited thereto. In an embodiment, the display driving circuit 200 may also be disposed (e.g., mounted) on the display circuit board 300, for example.

An end of the display circuit board 300 may be attached onto pads disposed on an edge of the sub-area SBA of the display device 10 using an anisotropic conductive film. The display circuit board 300 may be a flexible printed circuit board that may be bent, a rigid printed circuit board that maintains a flat shape, or a composite printed circuit board including both a rigid printed circuit board and a flexible printed circuit board. The display circuit board 300 may be connected to signal pads disposed on a side of the sub-area SBA.

The touch driving circuit 400 may be disposed (e.g., mounted) on the display circuit board 300. The touch driving circuit 400 may be electrically connected to the touch sensor layer 150 of the display device 10.

The touch driving circuit 400 may transmit touch driving signals to driving lines of the touch sensor layer 150 and receive touch sensing signals from sensing lines. In addition, the touch driving circuit 400 may determine whether a user's touch or proximity has occurred by sensing amounts of charge change in capacitances based on the touch sensing signals.

The user's touch indicates that an object such as the user's finger or a pen directly touches an upper surface of a cover window disposed on a touch sensor layer. The user's proximity indicates that an object such as the user's finger or a pen hovers above the upper surface of the cover window.

The touch driving circuit 400 may output touch data including coordinates of the user's touch to the main processor 15 (refer to FIG. 2).

FIG. 5 is an enlarged view of area A of FIG. 3.

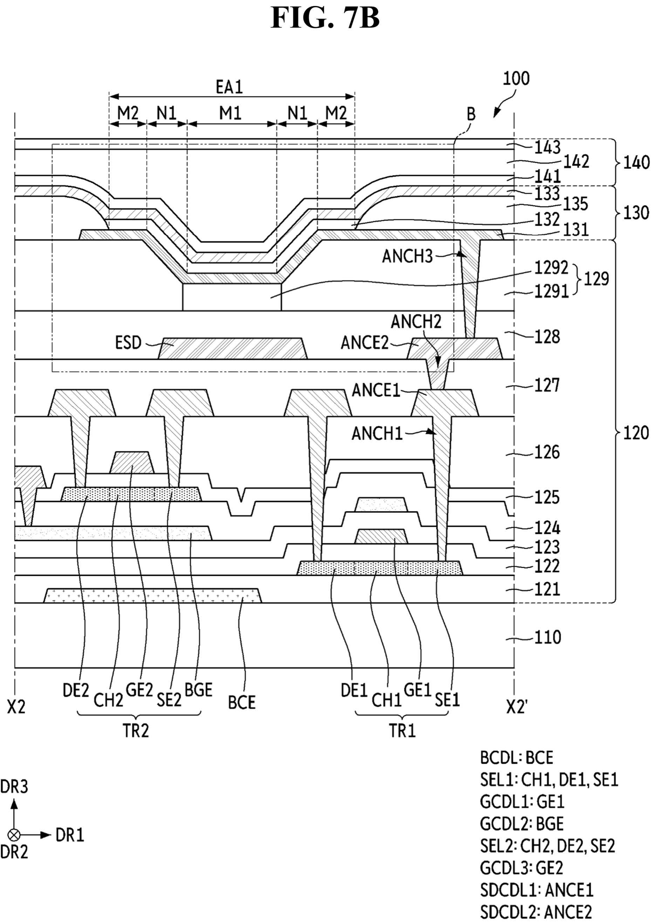

Referring to FIG. 5 in addition to FIG. 3, the display area DA of the display panel 100 may include emission areas EA1 through EA3, each emitting selected light. The emission areas EA1 through EA3 may be defined by a pixel defining layer 135 (refer to FIG. 7B). In an embodiment, the emission areas EA1 through EA3 may be defined as openings of the pixel defining layer 135 (refer to FIG. 7B), for example. In some embodiments, the emission areas EA1 through EA3 may include first emission areas EA1, second emission areas EA2, and third emission areas EA3.

Each of the emission areas EA1 through EA3 refers to an area which includes a pixel electrode 131, a light-emitting layer 132 (refer to FIG. 7B), and a common electrode 133 (refer to FIG. 7B) stacked sequentially.

Each of the first emission areas EA1, the second emission areas EA2, and the third emission areas EA3 may have a circular, elliptical, polygonal, or irregular planar shape. A case where the emission areas EA1 through EA3 have a circular shape will be described below as an example.

Pixels PX may each include one first emission area EA1, one third emission area EA3, and two second emission areas EA2. Here, in each of the pixels PX, the emission areas EA1 through EA3 may be arranged in a diamond shape. In an embodiment, in each of the pixels PX, the first emission area EA1 and the third emission area EA3 may neighbor each other in the first direction DR1, and the second emission areas EA2 may neighbor each other in the second direction DR2, for example.

In addition, in each of the pixels PX, the first emission area EA1 and any one second emission area EA2 may neighbor each other in a first diagonal direction DR4, and the first emission area EA1 and a remaining (the other) second emission area EA2 may neighbor each other in a second diagonal direction DR5. In addition, in each of the pixels PX, any one second emission area EA2 and the third emission area EA3 may neighbor each other in the second diagonal direction DR5, and a remaining (the other) second emission area EA2 and the third emission area EA3 may neighbor each other in the first diagonal direction DR4.

The first diagonal direction DR4 is a direction between the first direction DR1 and the second direction DR2. The second diagonal direction DR5 is a direction between the first direction DR1 and a direction opposite to the second direction DR2. In an embodiment, the first diagonal direction DR4 may be a direction inclined at 45 degrees to the first direction DR1 and the second direction DR2, and the second diagonal direction DR5 may be a direction inclined at 45 degrees to the first direction DR1 and the direction opposite to the second direction DR2.

In other words, the emission areas EA1 through EA3 of each of the pixels PX may be arranged as RGBG in a diamond shape.

The pixel electrode 131 may include a first portion 131a overlapping each of the emission areas EA1 through EA3 and a second portion 131b protruding from the first portion 131a in a direction. The first portion 131a may have, but is not limited to, a circular planar shape. The second portion 131b may be a portion protruding from the first portion 131a. The second portion 131b may be electrically connected to a second anode connection electrode ANCE2 (refer to FIG. 7B) through a third anode contact hole ANCH3 (refer to FIG. 7B).

The second portion 131b of the pixel electrode 131 in each of the first emission areas EA1 and the third emission areas EA3 may protrude from the first portion 131a in the first direction DR1. The second portion 131b of the pixel electrode 131 in each of the second emission areas EA2 may protrude from the first portion 131a in the second direction DR2.

Here, the first emission areas EA1 may emit first light in a blue wavelength band, the second emission areas EA2 may emit second light in a green wavelength band, and the third emission areas EA3 may emit third light in a red wavelength band. In an embodiment, the blue wavelength band may indicate that a main peak wavelength of light is included in a wavelength band of about 370 nanometers (nm) to 460 nm, the green wavelength band may indicate that a main peak wavelength of light is included in a wavelength band of about 480 nm to 560 nm, and the red wavelength band may indicate that a main peak wavelength of light is included in a wavelength band of about 600 nm to 750 nm, for example.

In addition, the area of each first emission area EA1 may be larger than the area of each third emission area EA3, and the area of each third emission area EA3 may be larger than the area of each second emission area EA2.

In an embodiment, a diameter of each first emission area EA1 may be 17 micrometers (µm) to 19 µm, a diameter of each second emission area EA2 may be 16 µm to 18 µm, and a diameter of each third emission area EA3 may be 22 µm to 23 µm, for example.

Although each of the pixels PX includes four emission areas EA1 through EA3 in FIG. 5, the disclosure is not limited thereto. That is, each of the pixels PX may also include three emission areas.

In addition, the arrangement of the emission areas EA1 through EA3 in each of the pixels PX is not limited to that illustrated in FIG. 5. In an embodiment, in each of the pixels PX, the emission areas EA1 through EA3 may also be arranged in a stripe structure in which the emission areas EA1 through EA3 are arranged in the first direction DR1, in a PenTile^{®} structure in which the emission areas EA1 through EA3 are arranged in a diamond shape as in FIG. 5, or in a hexagonal structure in which emission areas having a hexagonal planar shape are arranged, for example.

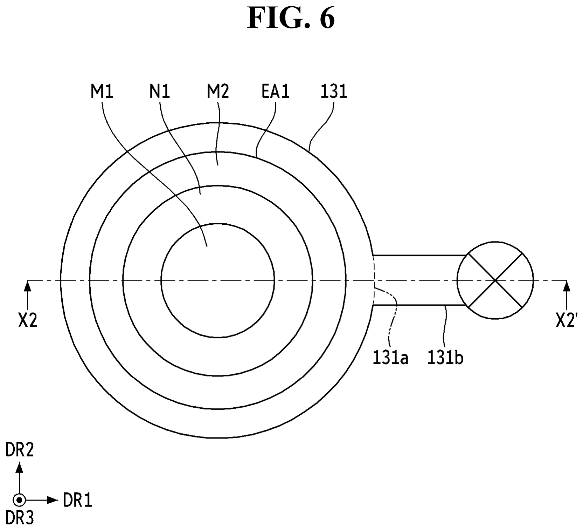

FIG. 6 is an enlarged plan view of an embodiment of the pixel electrode 131 of a first emission area EA1 in FIG. 5.

The pixel electrode 131 of each of the second emission areas EA2 and the third emission areas EA3 may be formed substantially identically to the pixel electrode 131 disposed in each of the first emission areas EA1. Therefore, a detailed description of the pixel electrode 131 disposed in each of the second emission areas EA2 and the third emission areas EA3 will be omitted.

Referring to FIG. 6, a first emission area EA1 may include a first flat portion M1, a first inclined portion N1, and a second flat portion M2.

The first flat portion M1 may be disposed at the center of the first emission area EA1. The first flat portion M1 may be an area where an upper surface of the pixel electrode 131 is flat, or an inclination angle of the upper surface of the pixel electrode 131 is less than a first angle. In some embodiments, the first angle may be about 3 degrees. That is, the first flat portion M 1 may be an area where the upper surface of the pixel electrode 131 is flat or nearly flat. Here, the inclination angle of the upper surface (e.g., a first upper surface portion) of the pixel electrode 131 in the first flat portion M1 refers to an acute angle among the angles defined by an extension line parallel to the upper surface (e.g., the first upper surface portion) of the pixel electrode 131 disposed in the first flat portion M1 and an extension line parallel to an upper surface of the substrate 110.

Since the first flat portion M1 is an area where the upper surface of the pixel electrode 131 is flat or nearly flat, it may be an area where light generated from the light-emitting layer 132 (refer to FIG. 7B) is emitted toward the front.

The planar shape of the first flat portion M1 may follow the planar shape of the first emission area EA1. When the first emission area EA1 has a circular planar shape as in FIG. 6, the first flat portion M1 may also have a circular planar shape.

The first inclined portion N1 may be formed to surround the periphery of the first flat portion M1. The first inclined portion N1 may be disposed between the first flat portion M1 and the second flat portion M2.

The first inclined portion N1 may be an area where the inclination angle of the upper surface of the pixel electrode 131 is equal to or greater than the first angle. Here, the inclination angle of the upper surface (e.g., a third upper surface portion) of the pixel electrode 131 in the first inclined portion N1 refers to an acute angle among the angles defined by an extension line parallel to the upper surface (e.g., the third upper surface portion) of the pixel electrode 131 disposed in the first inclined portion N1 and the extension line parallel to the upper surface of the substrate 110.

Since a slope of the first angle or greater is formed in the pixel electrode 131 in the first inclined portion N1, the first inclined portion N1 may be an area where light generated from the light-emitting layer 132 (refer to FIG. 7B) is emitted toward the side of the display device 10. The planar shape of the first inclined portion N1 may be a round ring or round loop shape with a hollow center, like a donut.

The second flat portion M2 may be formed to surround the periphery of the first inclined portion N1. The second flat portion M2 may be an area where the upper surface of the pixel electrode 131 is flat, or the inclination angle of the pixel electrode 131 is less than the first angle. That is, the second flat portion M2 may be an area where the upper surface of the pixel electrode 131 is flat or nearly flat. Here, the inclination angle of the upper surface (e.g., a second upper surface portion) of the pixel electrode 131 in the second flat portion M2 refers to an acute angle among the angles defined by an extension line parallel to the upper surface (e.g., the second upper surface portion) of the pixel electrode 131 disposed in the second flat portion M2 and the extension line parallel to the upper surface of the substrate 110.

Since the second flat portion M2 is an area where the upper surface of the pixel electrode 131 is flat or nearly flat, it may be an area where light generated from the light-emitting layer 132 (refer to FIG. 7B) is emitted toward the front.

The planar shape of the second flat portion M2 may be a round ring or round loop shape with a hollow center, like a donut.

The display device 10 in the illustrated embodiment may secure a process margin for forming the first inclined portion N1 and the emission areas EA1 through EA3 by including the second flat portion M2. In an embodiment, the position and width of an emission area EA1, EA2 or EA3 and the position and width of the first inclined portion N1 may be determined based on an approximate center of an opening of the pixel defining layer 135 (refer to FIG. 7B), for example. At this time, even when a reference point deviates from the approximate center of the opening of the pixel defining layer 135 (refer to FIG. 7B) by a selected distance, a safety process margin may be secured by the second flat portion M2.

In addition, the display device 10 in the illustrated embodiment may minimize a decrease in front luminance by including the second flat portion M2, even when it includes the first inclined portion N1 to increase side luminance.

The first flat portion M1 and the second flat portion M2 may be spaced apart from each other, and the first inclined portion N1 may be disposed between the first flat portion M1 and the second flat portion M2.

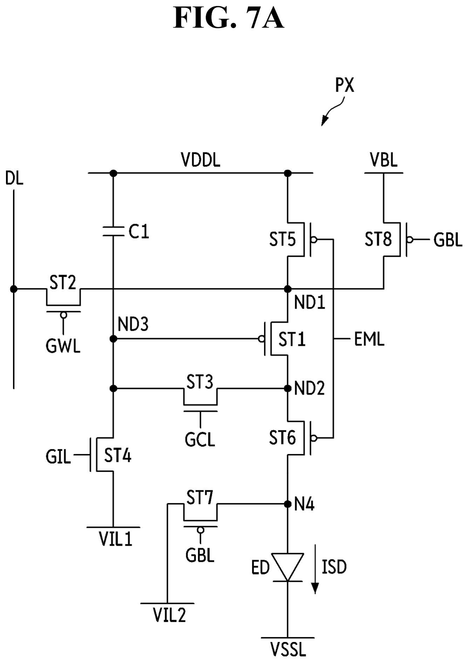

FIG. 7A is a circuit diagram of an embodiment of a pixel circuit of a display device 10.

Referring to FIG. 7A, a pixel PX may be connected to a first gate line GWL, a second gate line GCL, a third gate line GIL, a fourth gate line GBL, an emission control line EML, a data line DL, a driving voltage line VDDL, a first initialization voltage line VIL1, a second initialization voltage line VIL2, a bias voltage line VBL, and a low potential line VSSL.

The pixel PX may include a light-emitting element ED and a light-emitting pixel circuit which drives the light-emitting element ED. The light-emitting pixel circuit may include first through eighth transistors ST1 through ST8 and a first capacitor C1.

The first transistor ST1 may control a driving current supplied to the light-emitting element ED. The first transistor ST1 may include a gate electrode, a first electrode, and a second electrode. The first transistor ST1 may include the gate electrode connected to a third node ND3, the first electrode connected to a first node ND1, and the second electrode connected to a second node ND2. In an embodiment, the first electrode of the first transistor ST1 may be a source electrode, and the second electrode of the first transistor ST1 may be a drain electrode, for example, but the disclosure is not limited thereto.

The first transistor ST1 may control a source-drain current (hereinafter, also referred to as a "driving current") according to a data voltage applied to the gate electrode. The driving current Isd flowing through a channel of the first transistor ST1 may be proportional to the square of a difference between a voltage Vsg between the source electrode and the gate electrode of the first transistor ST1 and a threshold voltage Vth (Isd = k×(Vsg - Vth)²), where k is a proportional coefficient determined by the structure and physical characteristics of the first transistor ST1, Vsg is a source-gate voltage of the first transistor ST1, and Vth is a threshold voltage of the first transistor ST1.

The light-emitting element ED may receive the driving current and emit light. The amount of light emitted from the light-emitting element ED or the luminance of the light-emitting element ED may be proportional to the magnitude of the driving current. The light-emitting element ED may include a first electrode, a second electrode, and a light-emitting layer disposed between the first electrode and the second electrode. The first electrode of the light-emitting element ED may be connected to a fourth node N4. The first electrode of the light-emitting element ED may be connected to a second electrode of the sixth transistor ST6 and a first electrode of the seventh transistor ST7 through the fourth node N4. The second electrode of the light-emitting element ED may be electrically connected to the low potential line VSSL. The second electrode of the light-emitting element ED may receive a low potential voltage from the low potential line VSSL. In an embodiment, the first electrode of the light-emitting element ED may be an anode or a pixel electrode, and the second electrode of the light-emitting element ED may be a cathode or a common electrode, for example, but the disclosure is not limited thereto.

The second transistor ST2 may be turned on by a first gate signal of the first gate line GWL to electrically connect the data line DL and the first node ND1 which is the first electrode of the first transistor ST1. The second transistor ST2 turned on based on the first gate signal may supply a data voltage to the first node ND1. The second transistor ST2 may include a gate electrode connected to the first gate line GWL, a first electrode connected to the data line DL, and a second electrode connected to the first node ND1. The second electrode of the second transistor ST2 may be connected to the first electrode of the first transistor ST1, a second electrode of the fifth transistor ST5, and a second electrode of the eighth transistor ST8 through the first node ND1. In an embodiment, the first electrode of the second transistor ST2 may be a source electrode, and the second electrode of the second transistor ST2 may be a drain electrode, for example, but the disclosure is not limited thereto.

The third transistor ST3 may be turned on by a second gate signal of the second gate line GCL to electrically connect the second node ND2 which is the second electrode of the first transistor ST1 and the third node ND3 which is the gate electrode of the first transistor ST1. The third transistor ST3 may include a gate electrode connected to the second gate line GCL, a first electrode connected to the second node ND2, and a second electrode connected to the third node ND3. The first electrode of the third transistor ST3 may be connected to the second electrode of the first transistor ST1 and a first electrode of the sixth transistor ST6 through the second node ND2. The second electrode of the third transistor ST3 may be connected to the gate electrode of the first transistor ST1, a first electrode of the fourth transistor ST4, and a first capacitor electrode of the first capacitor C1 through the third node ND3. In an embodiment, the first electrode of the third transistor ST3 may be a drain electrode, and the second electrode of the third transistor ST3 may be a source electrode, for example, but the disclosure is not limited thereto.

The fourth transistor ST4 may be turned on by a third gate signal of the third gate line GIL to electrically connect the third node ND3 which is the gate electrode of the first transistor ST1 and the first initialization voltage line VIL1. The fourth transistor ST4 turned on based on the third gate signal may discharge the gate electrode of the first transistor ST1 to a first initialization voltage. The fourth transistor ST4 may include a gate electrode connected to the third gate line GIL, the first electrode connected to the third node ND3, and a second electrode connected to the first initialization voltage line VIL1. The first electrode of the fourth transistor ST4 may be connected to the gate electrode of the first transistor ST1, the second electrode of the third transistor ST3, and the first capacitor electrode of the first capacitor C1 through the third node ND3. In an embodiment, the first electrode of the fourth transistor ST4 may be a drain electrode, and the second electrode of the fourth transistor ST4 may be a source electrode, for example, but the disclosure is not limited thereto.

The fifth transistor ST5 may be turned on by an emission signal of the emission control line EML to electrically connect the driving voltage line VDDL and the first node ND1 which is the first electrode of the first transistor ST1. The fifth transistor ST5 may include a gate electrode connected to the emission control line EML, a first electrode connected to the driving voltage line VDDL, and the second electrode connected to the first node ND1. The second electrode of the fifth transistor ST5 may be electrically connected to the first electrode of the first transistor ST1, the second electrode of the second transistor ST2, and the second electrode of the eighth transistor ST8 through the first node ND1. In an embodiment, the first electrode of the fifth transistor ST5 may be a source electrode, and the second electrode of the fifth transistor ST5 may be a drain electrode, for example, but the disclosure is not limited thereto.

The sixth transistor ST6 may be turned on by the emission signal of the emission control line EML to electrically connect the second node ND2 which is the second electrode of the first transistor ST1 and the fourth node N4 which is the first electrode of the light-emitting element ED. The sixth transistor ST6 may include a gate electrode connected to the emission control line EML, the first electrode connected to the second node ND2, and the second electrode connected to the fourth node N4. The first electrode of the sixth transistor ST6 may be connected to the second electrode of the first transistor ST1 and the first electrode of the third transistor ST3 through the second node ND2. The second electrode of the sixth transistor ST6 may be connected to the first electrode of the light-emitting element ED and the first electrode of the seventh transistor ST7 through the fourth node N4. In an embodiment, the first electrode of the sixth transistor ST6 may be a source electrode, and the second electrode of the sixth transistor ST6 may be a drain electrode, for example, but the disclosure is not limited thereto.

When the fifth transistor ST5, the first transistor ST1, and the sixth transistor ST6 are all turned on, the driving current Isd may be supplied to the light-emitting element ED.

The seventh transistor ST7 may be turned on by a fourth gate signal of the fourth gate line GBL to electrically connect the second initialization voltage line VIL2 and the fourth node N4 which is the first electrode of the light-emitting element ED. The seventh transistor ST7 turned on based on the fourth gate signal may discharge the first electrode of the light-emitting element ED to a second initialization voltage. The seventh transistor ST7 may include a gate electrode connected to the fourth gate line GBL, the first electrode connected to the fourth node N4, and a second electrode connected to the second initialization voltage line VIL2. The first electrode of the seventh transistor ST7 may be connected to the first electrode of the light-emitting element ED and the second electrode of the sixth transistor ST6 through the fourth node N4. In an embodiment, the first electrode of the seventh transistor ST7 may be a source electrode, and the second electrode of the seventh transistor ST7 may be a drain electrode, for example, but the disclosure is not limited thereto.

The eighth transistor ST8 may be turned on by a fourth gate signal of the fourth gate line GBL to electrically connect the bias voltage line VBL and the first node ND1 which is the first electrode of the first transistor ST1. The eighth transistor ST8 may include a gate electrode connected to the fourth gate line GBL, a first electrode connected to the bias voltage line VBL, and the second electrode connected to the first node ND1. The second electrode of the eighth transistor ST8 may be electrically connected to the first electrode of the first transistor ST1, the second electrode of the second transistor ST2, and the second electrode of the fifth transistor ST5 through the first node ND1. In an embodiment, the first electrode of the eighth transistor ST8 may be a source electrode, and the second electrode of the eighth transistor ST8 may be a drain electrode, for example, but the disclosure is not limited thereto. Optionally, the eighth transistor ST8 may be omitted.

Each of the first transistor ST1, the second transistor ST2, the fifth transistor ST5, the sixth transistor ST6, the seventh transistor ST7, and the eighth transistor ST8 may include a silicon-based semiconductor region. In an embodiment, each of the first transistor ST1, the second transistor ST2, the fifth transistor ST5, the sixth transistor ST6, the seventh transistor ST7, and the eighth transistor ST8 may include a semiconductor region including low temperature polycrystalline silicon ("LTPS"), for example. The semiconductor region including LTPS may have relatively high electron mobility and excellent turn-on characteristics. Therefore, the display device 10 may stably and efficiently drive a plurality of pixels PX by including the first transistor ST1, the second transistor ST2, the fifth transistor ST5, the sixth transistor ST6, the seventh transistor ST7, and the eighth transistor ST8 having excellent turn-on characteristics.

Each of the first transistor ST1, the second transistor ST2, the fifth transistor ST5, the sixth transistor ST6, the seventh transistor ST7, and the eighth transistor ST8 may correspond to a p-type transistor. In an embodiment, each of the first transistor ST1, the second transistor ST2, the fifth transistor ST5, the sixth transistor ST6, the seventh transistor ST7, and the eighth transistor ST8 may output a current, which flows into the first electrode, to the second electrode based on a gate-low voltage applied to the gate electrode, for example.

Each of the third transistor ST3 and the fourth transistor ST4 may include an oxide-based semiconductor region. In an embodiment, each of the third transistor ST3 and the fourth transistor ST4 may have a coplanar structure in which the gate electrode is disposed on the oxide-based semiconductor region, for example. A transistor having the coplanar structure has excellent leakage current characteristics and may be driven at a relatively low frequency, thereby reducing power consumption. Therefore, the display device 10 may prevent leakage current from flowing inside a light-emitting pixel and may stably maintain a voltage inside the light-emitting pixel by including the third transistor ST3 and the fourth transistor ST4 having excellent leakage current characteristics.

Each of the third transistor ST3 and the fourth transistor ST4 may correspond to an n-type transistor. In an embodiment, each of the third transistor ST3 and the fourth transistor ST4 may output a current, which flows into the first electrode, to the second electrode based on a gate-high voltage applied to the gate electrode, for example.

The first capacitor C1 may be connected between the third node ND3, which is the gate electrode of the first transistor ST1, and the driving voltage line VDDL. In an embodiment, the first capacitor electrode of the first capacitor C1 may be connected to the third node ND3, and a second capacitor electrode of the first capacitor C1 may be connected to the driving voltage line VDDL, thereby maintaining a potential difference between the driving voltage line VDDL and the gate electrode of the first transistor ST1, for example.

Although the pixel circuit includes eight transistors and one capacitor ("8T1C structure") in the drawing, the disclosure is not limited thereto. The number of transistors and capacitors and the connection relationship between them may be variously changed.

FIG. 7B is a cross-sectional view taken along line X2-X2' of FIG. 6.

Referring to FIG. 7 in addition to FIGS. 4 and 5, the display panel 100 may include the substrate 110, the circuit layer 120 on the substrate 110, the element layer 130 on the circuit layer 120, and the sealing layer 140 on the element layer 130. As described above with reference to FIG. 4, the display panel 100 may further include the touch sensor layer 150 on the sealing layer 140 and the color filter layer 160 on the touch sensor layer 150. In the following description, the substrate 110, the circuit layer 120, the element layer 130, and the sealing layer 140 will be mainly described.

The substrate 110 may include an insulating material such as polymer resin. In an embodiment, the substrate 110 may include polyimide, for example. The substrate 110 may be a flexible substrate that may be bent, folded, rolled, etc. In an alternative embodiment, the substrate 110 may include an insulating material such as glass. In an embodiment, the substrate 110 may include a plurality of organic layers and an inorganic layer included between the organic layers.

The circuit layer 120 may include a first transistor TR1 and a second transistor TR2. Each of the first transistor TR1 and the second transistor TR2 may have the same configuration as any one of the first through eighth transistors ST1 through ST8 described above with reference to FIG. 7A. In an embodiment, when a pixel circuit of the display device 10 includes an 8T1C structure as described above with reference to FIG. 7A, the first transistor TR1 illustrated in FIG. 7B may have the same configuration as the sixth transistor ST6 illustrated in FIG. 7A, and the second transistor TR2 illustrated in FIG. 7B may have the same configuration as the fourth transistor ST4 illustrated in FIG. 7A, for example.

The first transistor TR1 may include a channel portion CH1, a first electrode SE1, a second electrode DE1, and a gate electrode GE1. The channel portion CH1 of the first transistor TR1 may overlap the gate electrode GE1, and the first electrode SE1 and the second electrode DE1 may be connected to one side and an opposite side of the channel portion CH1, respectively.

The second transistor TR2 may include a channel portion CH2, a first electrode SE2, a second electrode DE2, and a gate electrode GE2. In some embodiments, the second transistor TR2 may further include a bottom gate electrode BGE. The channel portion CH2 of the second transistor TR2 may overlap the gate electrode GE2 and the bottom gate electrode BGE, and the first electrode SE2 and the second electrode DE2 may be connected to one side and an opposite side of the channel portion CH2, respectively.

In some embodiments, at least of the first transistor TR1 and the second transistor TR2 may be an oxide transistor including an oxide semiconductor. In an embodiment, an active layer (or a semiconductor layer) of the second transistor TR2 may include an oxide semiconductor, and an active layer (or a semiconductor layer) of the first transistor TR1 may include a silicon semiconductor including a semiconductor material (e.g., amorphous silicon or polysilicon) other than the oxide semiconductor, for example. However, the disclosure is not limited thereto, and the first transistor TR1 may also include an oxide semiconductor and the second transistor TR2 may also include a silicon semiconductor, or both the first transistor TR1 and the second transistor TR2 may include a silicon semiconductor or an oxide semiconductor.

A case where the second transistor TR2 includes an oxide semiconductor and the first transistor TR1 includes a silicon semiconductor will be described below as an example.

The circuit layer 120 may include a bottom conductive layer BCDL, a buffer layer 121, a first semiconductor layer SEL1, a first gate insulating layer 122, a first gate conductive layer GCDL1, a second gate insulating layer 123, a second gate conductive layer GCDL2, a first inter-insulating layer 124, a second semiconductor layer SEL2, a third gate insulating layer 125, a third gate conductive layer GCDL3, a second inter-insulating layer 126, a first source-drain conductive layer SDCDL1, a first planarization layer 127, a second source-drain conductive layer SDCDL2, a second planarization layer 128, and an under-anode insulating layer 129.

The bottom conductive layer BCDL may be disposed on the substrate 110. The bottom conductive layer BCDL may be formed as a single layer or a multilayer including any one or more of molybdenum (Mo), aluminum (Al), chromium (Cr), gold (Au), titanium (Ti), nickel (Ni), neodymium (Nd), copper (Cu), and alloys thereof. The bottom conductive layer BCDL may include a bottom electrode BCE.

The buffer layer 121 may be disposed on the bottom conductive layer BCDL. The buffer layer 121 may cover the bottom conductive layer BCDL and the substrate 110. In an embodiment, the buffer layer 121 may be disposed on the entirety of the surface of the substrate 110, for example. The buffer layer 121 may insulate the bottom conductive layer BCDL from the first semiconductor layer SELl.

The buffer layer 121 may protect transistors of the circuit layer 120 and the light-emitting layer 132 of the element layer 130 from moisture introduced through the substrate 110 which is vulnerable to moisture penetration. The buffer layer 121 may consist of a plurality of inorganic layers stacked alternately. In an embodiment, the buffer layer 121 may be a multilayer or a single layer in which one or more inorganic layers selected from a silicon nitride layer, a silicon oxynitride layer, a silicon oxide layer, a titanium oxide layer, and an aluminum oxide layer are alternately stacked, for example. In an embodiment, the buffer layer 121 may be a laminate of a silicon oxide layer and a silicon nitride layer.

The first semiconductor layer SEL1 may be disposed on the buffer layer 121. The first semiconductor layer SEL1 may include polycrystalline silicon, monocrystalline silicon, low-temperature polycrystalline silicon, amorphous silicon, or an oxide semiconductor material. In an embodiment, as described above, the first semiconductor layer SEL1 may include a silicon semiconductor material such as polysilicon or amorphous silicon, for example. The first semiconductor layer SEL1 may include the channel portion CH1, the first electrode SE1, and the second electrode DE1 of the first transistor TR1.

The first gate insulating layer 122 may be disposed on the first semiconductor layer SEL1. The first gate insulating layer 122 may cover the first semiconductor layer SEL1 and the buffer layer 121. The first gate insulating layer 122 may insulate the first semiconductor layer SEL1 from the first gate conductive layer GCDL1.

The first gate insulating layer 122 may be a multilayer or a single layer in which one or more inorganic layers selected from a silicon nitride layer, a silicon oxynitride layer, a silicon oxide layer, a titanium oxide layer, and an aluminum oxide layer are alternately stacked, for example. In an embodiment, the first gate insulating layer 122 may be a single silicon oxide layer.

The first gate conductive layer GCDL1 may be disposed on the first gate insulating layer 122. The first gate conductive layer GCDL1 may be formed as a single layer or a multilayer including any one or more of molybdenum (Mo), aluminum (Al), chromium (Cr), gold (Au), titanium (Ti), nickel (Ni), neodymium (Nd), copper (Cu), and alloys thereof. The first gate conductive layer GCDL1 may include the gate electrode GE1 of the first transistor TR1.

The second gate insulating layer 123 may be disposed on the first gate conductive layer GCDL1. The second gate insulating layer 123 may cover the first gate conductive layer GCDL1 and the first gate insulating layer 122. The second gate insulating layer 123 may insulate the first gate conductive layer GCDL1 from the second gate conductive layer GCDL2.

The second gate insulating layer 123 may be a multilayer or a single layer in which one or more inorganic layers selected from a silicon nitride layer, a silicon oxynitride layer, a silicon oxide layer, a titanium oxide layer, and an aluminum oxide layer are alternately stacked, for example. In an embodiment, the second gate insulating layer 123 may be a single silicon nitride layer.

The second gate conductive layer GCDL2 may be disposed on the second gate insulating layer 123. The second gate conductive layer GCDL2 may be formed as a single layer or a multilayer including any one or more of molybdenum (Mo), aluminum (Al), chromium (Cr), gold (Au), titanium (Ti), nickel (Ni), neodymium (Nd), copper (Cu), and alloys thereof. The second gate conductive layer GCDL2 may include the bottom gate electrode BGE of the second transistor TR2.

The first inter-insulating layer 124 may be disposed on the second gate conductive layer GCDL2. The first inter-insulating layer 124 may cover the second gate conductive layer GCDL2 and the second gate insulating layer 123. The first inter-insulating layer 124 may insulate the second gate conductive layer GCDL2 from the second semiconductor layer SEL2.

The first inter-insulating layer 124 may be a multilayer or a single layer in which one or more inorganic layers selected from a silicon nitride layer, a silicon oxynitride layer, a silicon oxide layer, a titanium oxide layer, and an aluminum oxide layer are alternately stacked, for example. In an embodiment, the first inter-insulating layer 124 may be a laminate of a silicon oxide layer and a silicon nitride layer.

The second semiconductor layer SEL2 may be disposed on the first inter-insulating layer 124. The second semiconductor layer SEL2 may include polycrystalline silicon, monocrystalline silicon, low-temperature polycrystalline silicon, amorphous silicon, or an oxide semiconductor material. In an embodiment, as described above, the second semiconductor layer SEL2 may include an oxide semiconductor material, for example. The second semiconductor layer SEL2 may include the channel portion CH2, the first electrode SE2, and the second electrode DE2 of the second transistor TR2.

The third gate insulating layer 125 may be disposed on the second semiconductor layer SEL2. The third gate insulating layer 125 may cover the second semiconductor layer SEL2 and the first inter-insulating layer 124. The third gate insulating layer 125 may insulate the second semiconductor layer SEL2 from the third gate conductive layer GCDL3.

The third gate insulating layer 125 may be a multilayer or a single layer in which one or more inorganic layers selected from a silicon nitride layer, a silicon oxynitride layer, a silicon oxide layer, a titanium oxide layer, and an aluminum oxide layer are alternately stacked, for example. In an embodiment, the third gate insulating layer 125 may be a single silicon oxide layer.

The third gate conductive layer GCDL3 may be disposed on the third gate insulating layer 125. The third gate conductive layer GCDL3 may be formed as a single layer or a multilayer including any one or more of molybdenum (Mo), aluminum (Al), chromium (Cr), gold (Au), titanium (Ti), nickel (Ni), neodymium (Nd), copper (Cu), and alloys thereof. The third gate conductive layer GCDL3 may include the gate electrode GE2 of the second transistor TR2.

The second inter-insulating layer 126 may be disposed on the third gate conductive layer GCDL3. The second inter-insulating layer 126 may cover the third gate conductive layer GCDL3 and the third gate insulating layer 125. The second inter-insulating layer 126 may insulate the third gate conductive layer GCDL3 from the first source-drain conductive layer SDCDL1.

The second inter-insulating layer 126 may be a multilayer or a single layer in which one or more inorganic layers selected from a silicon nitride layer, a silicon oxynitride layer, a silicon oxide layer, a titanium oxide layer, and an aluminum oxide layer are alternately stacked, for example. In an embodiment, the first inter-insulating layer 124 may be a laminate of a silicon nitride layer and a silicon oxide layer.

The first source-drain conductive layer SDCDL1 may be disposed on the second inter-insulating layer 126. The first source-drain conductive layer SDCDL1 may be formed as a single layer or a multilayer including any one or more of molybdenum (Mo), aluminum (Al), chromium (Cr), gold (Au), titanium (Ti), nickel (Ni), neodymium (Nd), copper (Cu), and alloys thereof. The first source-drain conductive layer SDCDL1 may include first anode connection electrodes ANCE1.

A first anode connection electrode ANCE1 may be connected to the first electrode SE1 of the first transistor TR1 through a first anode contact hole ANCH1 penetrating the first gate insulating layer 122, the second gate insulating layer 123, the first inter-insulating layer 124, the third gate insulating layer 125, and the second inter-insulating layer 126.

The first planarization layer 127 may be disposed on the first source-drain conductive layer SDCDL1. The first planarization layer 127 may cover the first source-drain conductive layer SDCDL1 and the second inter-insulating layer 126. The first planarization layer 127 may planarize a step caused by the layers disposed under the first planarization layer 127. The first planarization layer 127 may insulate the first source-drain conductive layer SDCDL1 from the second source-drain conductive layer SDCDL2.

The first planarization layer 127 may include an organic layer such as acryl resin, epoxy resin, phenolic resin, polyamide resin, or polyimide resin.

The second source-drain conductive layer SDCDL2 may be disposed on the first planarization layer 127. The second source-drain conductive layer SDCDL2 may be formed as a single layer or a multilayer including any one or more of molybdenum (Mo), aluminum (Al), chromium (Cr), gold (Au), titanium (Ti), nickel (Ni), neodymium (Nd), copper (Cu), and alloys thereof. The second source-drain conductive layer SDCDL2 may include a second anode connection electrode ANCE2 and an under-anode conductive pattern ESD.

The second anode connection electrode ANCE2 may be connected to the first anode connection electrode ANCE1 through a second anode contact hole ANCH2 penetrating the first planarization layer 127.

The under-anode conductive pattern ESD may overlap the pixel electrode 131 in the third direction DR3. The under-anode conductive pattern (also referred to as a first conductive pattern) ESD refers to a conductive pattern closest to the pixel electrode 131 in the third direction DR3 (e.g., a vertical direction or a thickness direction of the substrate 110) among the conductive patterns disposed in the second source-drain conductive layer SDCDL2. In some embodiments, the under-anode conductive pattern ESD may be a conductive pattern that forms a part of or is electrically connected to the data line DL or the driving voltage line VDDL described above with reference to FIG. 7A.

The second planarization layer 128 may be disposed on the second source-drain conductive layer SDCDL2. The second planarization layer 128 may cover the second source-drain conductive layer SDCDL2 and the first planarization layer 127. The second planarization layer 128 may planarize a step caused by the layers disposed under the second planarization layer 128. The second planarization layer 128 may insulate the second source-drain conductive layer SDCDL2 from the pixel electrode 131.

The second planarization layer 128 may include an organic layer such as acryl resin, epoxy resin, phenolic resin, polyamide resin, or polyimide resin.

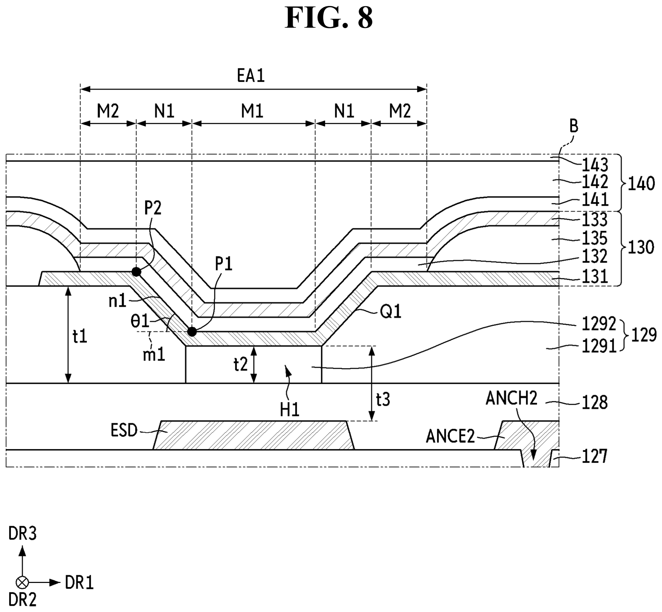

The under-anode insulating layer 129 may be disposed on the second planarization layer 128. The under-anode insulating layer 129 may include a first under-anode insulating layer 1291 and a second under-anode insulating layer 1292. The under-anode insulating layer 129 will be described later with reference to FIG. 8, etc.

The element layer 130 may be disposed on the under-anode insulating layer 129. The element layer 130 may include the pixel electrode 131, the light-emitting layer 132, the common electrode 133, and the pixel defining layer 135.

The pixel electrode 131 may be disposed on the under-anode insulating layer 129. The pixel electrode 131 may be connected to the second anode connection electrode ANCE2 through a third anode contact hole ANCH3 penetrating the second planarization layer 128 and the under-anode insulating layer 129.

In a top emission structure in which light is emitted in a direction from the light-emitting layer 132 toward the common electrode 133, the pixel electrode 131 may be formed as a single layer of molybdenum (Mo), titanium (Ti), copper (Cu) or aluminum (Al) or, in order to increase reflectivity, may be formed as a stacked structure (Ti/Al/Ti) of aluminum and titanium, a stacked structure (ITO/Al/ITO) of aluminum and indium tin oxide, an APC alloy, or a stacked structure (ITO/APC/ITO) of an APC alloy and indium tin oxide. The APC alloy is an alloy of silver (Ag), palladium (Pd), and copper (Cu).

The pixel defining layer 135 may be disposed on a portion of the pixel electrode 131. The pixel defining layer 135 serves to define the emission areas EA1 through EA3 of the pixels PX. The pixel defining layer 135 may be formed to expose a portion of the pixel electrode 131 on the under-anode insulating layer 129. The pixel defining layer 135 may partially cover edges of the pixel electrode 131. The pixel defining layer 135 may include an organic layer such as acryl resin, epoxy resin, phenolic resin, polyamide resin, or polyimide resin.

The light-emitting layer 132 may be disposed on the pixel electrode 131. Although the light-emitting layer 132 is disposed within an opening of the pixel defining layer 135 in the drawing, the disclosure is not limited thereto. In an embodiment, some elements (e.g., a hole transporting layer or an electron transporting layer) of the light-emitting layer 132 may be connected to those of other pixels PX as common layers, for example.

The light-emitting layer 132 may be an organic light-emitting layer including an organic material. In this case, the light-emitting layer 132 may include a hole transporting layer, an organic light-emitting layer, and an electron transporting layer. When an anode voltage is applied to the pixel electrode 131 through a thin-film transistor of the circuit layer 120 and a cathode voltage is applied to the common electrode 133, holes and electrons may move to the organic light-emitting layer through the hole transporting layer and the electron transporting layer, respectively. Then, the holes and the electrons may be combined with each other in the organic light-emitting layer to emit light.

The common electrode 133 may be disposed on the pixel defining layer 135 and the light-emitting layer 132. The common electrode 133 may be formed to cover the light-emitting layer 132. The common electrode 133 may be a common layer formed in common in all of the emission areas EA1 through EA3.

The sealing layer 140 may be disposed on the element layer 130. The sealing layer 140 may include a first inorganic encapsulation layer 141 and a second inorganic encapsulation layer 143 which serve to prevent oxygen or moisture from penetrating into the element layer 130. Each of the first inorganic encapsulation layer 141 and the second inorganic encapsulation layer 143 may be, but is not limited to, a silicon nitride layer, a silicon oxynitride layer, a silicon oxide layer, a titanium oxide layer, or an aluminum oxide layer.

In addition, the sealing layer 140 may include a first organic encapsulation layer 142 which serves to protect the element layer 130 from foreign substances such as dust. The first organic encapsulation layer 142 may be disposed between the first inorganic encapsulation layer 141 and the second inorganic encapsulation layer 143. The first organic encapsulation layer 142 may be, but is not limited to, acryl resin, epoxy resin, phenolic resin, polyamide resin, or polyimide resin.

The sealing layer 140 may be disposed in both the display area DA and the non-display area NDA. Specifically, the sealing layer 140 may cover the element layer 130 of the display area DA and the non-display area NDA and cover the circuit layer 120 of the non-display area NDA.

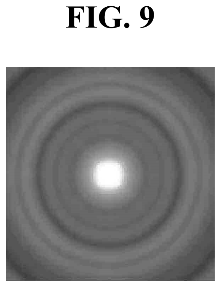

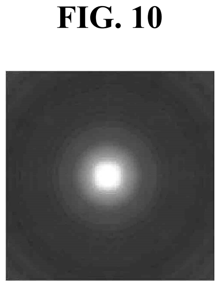

FIG. 8 is an enlarged view of area B of FIG. 7B. FIG. 9 is a photograph of a reflection diffraction pattern of a display device 10 according to a comparative example. FIG. 10 is a photograph of an embodiment of a reflection diffraction pattern of the display device 10.

Referring to FIGS. 8 through 10 in addition to FIGS. 6 and 7B, in the first flat portion M1 and the second flat portion M2, an upper surface of the under-anode insulating layer 129 may be flat, or an inclination angle of the upper surface of the under-anode insulating layer 129 may be less than the first angle. In an embodiment, the first angle may be about 3 degrees, for example. When the slope of the upper surface of the under-anode insulating layer 129 is less than about 3 degrees, the upper surface of the under-anode insulating layer 129 may be considered to be substantially flat without a slope. Here, the inclination angle of the upper surface of the under-anode insulating layer 129 in the first flat portion M1 or the second flat portion M2 refers to an acute angle among the angles defined by an extension line parallel to the upper surface of the under-anode insulating layer 129 disposed in the first flat portion M1 or the second flat portion M2 and the extension line parallel to the upper surface of the substrate 110. In an embodiment, a portion of the under-anode insulating layer 129 corresponding to the first flat portion M1 may be also referred to as a first portion of the under-anode insulating layer 129, a portion of the under-anode insulating layer 129 corresponding to the second flat portion M2 may be also referred to as a second portion of the under-anode insulating layer 129, and a portion of the under-anode insulating layer 129 corresponding to the N1 flat portion M1 may be also referred to as a third portion of the under-anode insulating layer 129, for example.

In the first inclined portion N1, the inclination angle of the upper surface of the under-anode insulating layer 129 may be equal to or greater than the first angle. Here, the inclination angle of the upper surface of the under-anode insulating layer 129 in the first inclined portion N1 refers to an acute angle among the angles defined by an extension line parallel to the upper surface of the under-anode insulating layer 129 disposed in the first inclined portion N1 and the extension line parallel to the upper surface of the substrate 110.

In the specification, boundaries between the first flat portion M1, the first inclined portion N1, and the second flat portion M2 may be based on the degree of slope of the upper surface of the pixel electrode 131. In an embodiment, the first flat portion M1 and the second flat portion M2 may be areas where the upper surface of the pixel electrode 131 is flat, and the first inclined portion N1 may be an area where the upper surface of the pixel electrode 131 is inclined, for example.

Since the shape of the pixel electrode 131 corresponds to the shape of the upper surface of the under-anode insulating layer 129, the boundaries between the first flat portion M1, the first inclined portion N1, and the second flat portion M2 may also be based on the degree of slope of the upper surface of the under-anode insulating layer 129. In an embodiment, the first flat portion M1 and the second flat portion M2 may be areas where the upper surface of the under-anode insulating layer 129 is flat, and the first inclined portion N1 may be an area where the upper surface of the under-anode insulating layer 129 is inclined, for example.

The under-anode insulating layer 129 may include the first under-anode insulating layer 1291 and the second under-anode insulating layer 1292.

The first under-anode insulating layer 1291 may be disposed on the second planarization layer 128. The first under-anode insulating layer 1291 may define a first hole H1. The first hole H1 may be defined approximately at the center of the first emission area EA1. A central portion of the first hole H1 may overlap the first flat portion M1, and an edge portion of the first hole H1 may overlap the first inclined portion N1.

The first under-anode insulating layer 1291 may include a first inclined surface Q1. The first inclined surface Q1 may be disposed on a side of the first hole H1. The first inclined surface Q1 may surround the first hole H1 in a plan view. The first inclined surface Q1 may be an inner surface surrounding the first hole H1 in a plan view. The first inclined portion N1 may have a selected slope along the shape of the first inclined surface Q1.

The second under-anode insulating layer 1292 may be disposed within the first hole H1 of the first under-anode insulating layer 1291. The second under-anode insulating layer 1292 may be disposed on the second planarization layer 128 exposed in the first hole H1.

An upper surface of the second under-anode insulating layer 1292 may be flat, or the slope of the upper surface of the under-anode insulating layer 129 may be less than the first angle. The first flat portion M1 may be flat along the shape of the upper surface of the second under-anode insulating layer 1292.

The shapes of the pixel electrode 131, the light-emitting layer 132, and the common electrode 133 may follow the shape of the upper surface of the under-anode insulating layer 129. Therefore, the pixel electrode 131, the light-emitting layer 132, and the common electrode 133 may be flat in the first flat portion M1 and the second flat portion M2 and may have a selected slope in the first inclined portion N1.

When an intersection of a flat surface (also referred to as a first sub-portion of the first upper surface portion) of the pixel electrode 131 disposed in the first flat portion M1 and an inclined surface (also referred to as a second sub-portion of the first upper surface portion) of the pixel electrode 131 disposed in the first inclined portion N1 is defined as a first point P1 and when an intersection of the inclined surface of the pixel electrode 131 disposed in the first inclined portion N1 and a flat surface of the pixel electrode 131 disposed in the second flat portion M2 is defined as a second point P2, a line connecting the first point P1 and the second point P2 may be defined as a first inclined line n1. An imaginary extension line extending parallel to the upper surface of the substrate 110 from the first point P1 toward an opposite side from the first flat portion M1 may be defined as a first extension line ml.

In the specification, the first extension line ml, the first inclined line n1, the first point P1, and the second point P2 are defined based on the upper surface of the pixel electrode 131. However, since the shape of the upper surface of the pixel electrode 131 may correspond to that of the upper surface of the under-anode insulating layer 129, the first extension line m1, the first inclined line n1, the first point P1, and the second point P2 may also be defined based on the upper surface of the under-anode insulating layer 129.

In some embodiments, a first inclination angle θ1 formed by the first extension line m1 and the first inclined line n1 may be about 20 degrees to 35 degrees. When the first extension line m1 and the first inclined line n1 have the first inclination angle θ1, light emitted from the first inclined portion N1 may travel toward the side of the display device 10. Therefore, the luminance and chrominance of the display panel 100 at each viewing angle may be adjusted according to the first inclination angle θ1. Here, the luminance at each viewing angle refers to a luminance value according to the angle with respect to the front of the display device 10. The chrominance at each viewing angle refers to the degree of color distortion according to the angle with respect to the front of the display device 10. At this time, the viewing angle is an angle at which a user of a display device looks at the display device. The viewing angle is 0 degrees when a viewer looks at a display device from the front. The viewing angle may increase as the viewer looks at the display device obliquely.

When the first inclination angle θ1 is less than 20 degrees, the luminance may decrease when an image of the display device 10 is viewed from the side of the display device 10 compared to when the image of the display device 10 is viewed from the front of the display device 10.

In addition, when the first inclination angle θ1 is less than 20 degrees, the upper surface of the pixel electrode 131 is almost parallel to the direction of the upper surface of the display device 10. When light emitted from the light-emitting layer 132 is refracted as it passes through a member such as the sealing layer 140, light having a long wavelength among white light emitted from the display device 10 travels in the third direction DR3, and light having a short wavelength among the white light travels in a direction intersecting the third direction DR3 due to a difference in refractive index according to the wavelength of light. Accordingly, when a white image of the display device 10 is viewed from the side of the display device 10, it looks somewhat blue compared to when the white image of the display device 10 is viewed from the front of the display device 10.

When the first inclination angle θ1 is 20 degrees or more, a long wavelength portion of light emitted from the first inclined portion N1 travels in the direction intersecting the third direction DR3. Accordingly, the phenomenon in which the white image of the display device 10 looks somewhat blue when viewed from the side may be reduced.

In addition, when the color filter layer 160 is disposed on the element layer 130, when the first inclination angle θ1 is 20 degrees or more, rainbow mura caused by diffraction of light in the color filter layer 160 may be minimized.

In an embodiment, in the display device 10 according to the comparative example, the first inclination angle θ1 may be less than 20 degrees (e.g., about 15 degrees), for example. In this case, as shown in FIG. 9, a reflection diffraction pattern may be distinctly generated. In the display device 10 in the illustrated embodiment, the first inclination angle θ1 may be 20 degrees or more. In this case, as shown in FIG. 10, a reflection diffraction pattern may be hardly generated.

The reflection diffraction patterns shown in FIGS. 9 and 10 are diffraction patterns detected by perpendicularly irradiating a circular light source having a selected diameter to the display devices 10 from a predetermined distance.

When the first inclination angle θ1 exceeds 35 degrees, a light trapping phenomenon in which light is trapped between the pixel electrode 131 and the common electrode 133 without being emitted may occur. In this case, since generated light is not emitted, both the luminance at the front and the luminance at the side of a display device may decrease. Accordingly, in the disclosure, the first inclination angle θ1 may be 20 to 35 degrees, thereby minimizing a decrease in front efficiency and minimizing the occurrence of mura while improving luminance and chrominance at each viewing angle when observed from the side.

A first thickness t1 of the first under-anode insulating layer 1291 and a second thickness t2 of the second under-anode insulating layer 1292 may be set such that the first inclination angle θ1 is within the above range. In an embodiment, the first thickness t1 may be about 2 µm or more, and the second thickness t2 may be about 1 µm or less, for example.

In some embodiments, a first distance t3, which is a distance between the under-anode conductive pattern ESD and the pixel electrode 131, may be about 2 µm or more. The first distance t3 refers to a distance between the pixel electrode 131 disposed in the first flat portion M1 and the under-anode conductive pattern ESD in the third direction DR3. In an embodiment, the first distance t3 may refer to a distance between a lower surface of the pixel electrode 131 disposed in the first flat portion M1 and an upper surface of the under-anode conductive pattern ESD in the third direction DR3, for example. When the first distance t3 is about 2 µm or more, electric field interference and optical interference may be reduced, thereby minimizing the occurrence of mura at relatively low luminance and relatively low grayscale levels.

In some embodiments, the first under-anode insulating layer 1291 may include an inorganic insulating layer. In an embodiment, the first under-anode insulating layer 1291 may include at least one of silicon nitride (SiNₓ), silicon oxide (SiOₓ), silicon nitride oxide (SiON), titanium oxide (TiOₓ), and aluminum oxide (AlOₓ), for example.

In the display device 10 in the illustrated embodiment, since the first under-anode insulating layer 1291 includes an inorganic insulating layer, it may be relatively easy to form the first inclination angle θ1 to a predetermined level or greater.

In an embodiment, when the first under-anode insulating layer 1291 includes an organic insulating layer, it has fluidity before being cured, for example. Therefore, an inclination angle of an inclined surface of the first under-anode insulating layer 1291 after being cured may be relatively small. Hence, when the first under-anode insulating layer 1291 includes an organic insulating layer, it must be formed thicker in order to realize a desired inclination angle. When the organic insulating layer is formed thick, the amount of outgas generated during the formation of the organic layer may increase, thus affecting the reliability of the display device 10.

When the first under-anode insulating layer 1291 includes an inorganic insulating layer, its shape may be easily controlled through a process such as dry etching. Therefore, the inclination angle of the inclined surface of the first under-anode insulating layer 1291 may be easily adjusted according to an etching method. Hence, when the first under-anode insulating layer 1291 includes an inorganic insulating layer, a minimum thickness for realizing the desired inclination angle is smaller, and the reliability problem due to outgas may also be overcome.

The second under-anode insulating layer 1292 may include an organic layer such as acryl resin, epoxy resin, phenolic resin, polyamide resin, or polyimide resin.

In the display device 10 in the illustrated embodiment, light may be emitted from both a flat portion and an inclined portion of the light-emitting layer 132. Accordingly, when the display device 10 is observed from the front, a decrease in front efficiency may be minimized because a long wavelength emitted from the flat portions M1 and M2 and a short wavelength emitted from the first inclined portion N1 are mixed. In addition, when the display device 10 is observed from the side, the phenomenon of color distortion and luminance reduction experienced when observed from the side compared to when observed from the front may be improved because a short wavelength emitted from the flat portions M1 and M2, a long wavelength emitted from the first inclined portion N1 on one side, and a long wavelength emitted from the first inclined portion N1 on an opposite side are mixed.

Hereinafter, other embodiments of the display device in the embodiment will be described. In the following embodiments, the same elements as those of the above-described embodiment are identified by the same reference characters, and any redundant description thereof will be omitted or given briefly, and differences will mainly be described.

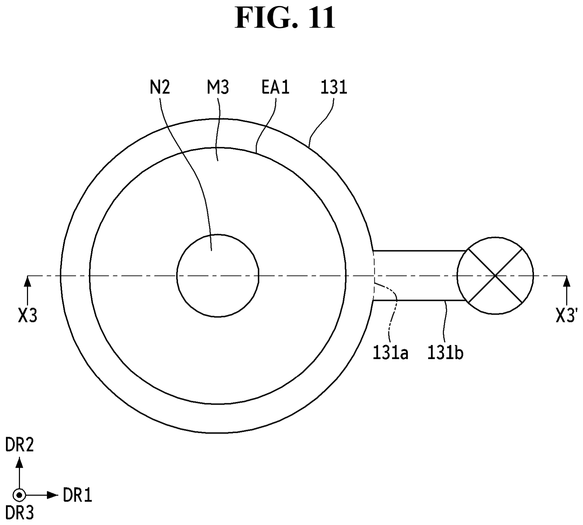

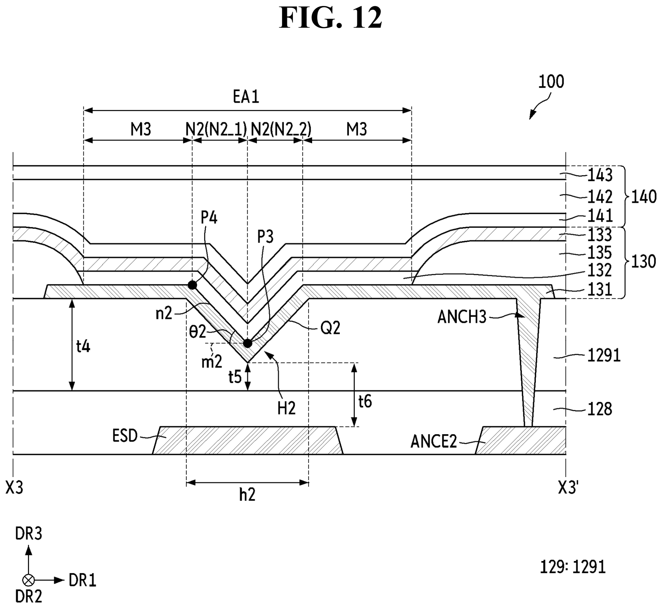

FIG. 11 is an enlarged plan view of an embodiment of a pixel electrode 131 of a first emission area EA1 of a display device 10. FIG. 12 is a cross-sectional view taken along line X3-X3' of FIG. 11.

Referring to FIGS. 11 and 12, the display device 10 in the illustrated embodiment is different from the display device 10 in the embodiment described with reference to FIG. 6, etc., in that it includes a first groove H2 instead of the first hole H1.

More specifically, the first emission area EA1 may include a second inclined portion N2 and a third flat portion M3.

The second inclined portion N2 may be disposed inside the third flat portion M3. The second inclined portion N2 may be an area where an inclination angle of an upper surface of the pixel electrode 131 is equal to or greater than a first angle. In some embodiments, the first angle may be about 3 degrees. Here, the inclination angle of the upper surface (e.g., a first upper surface portion) of the pixel electrode 131 in the second inclined portion N2 refers to an acute angle among the angles defined by an extension line parallel to the upper surface (e.g., the first upper surface portion) of the pixel electrode 131 disposed in the second inclined portion N2 and an extension line parallel to an upper surface of a substrate 110.

Since a slope of the first angle or greater is formed in the pixel electrode 131 in the second inclined portion N2, the second inclined portion N2 may be an area where light generated from a light-emitting layer 132 is emitted toward the side of the display device 10.

The planar shape of the second inclined portion N2 may follow the planar shape of the first emission area EA1. When the first emission area EA1 has a circular planar shape as in FIG. 11, the second inclined portion N2 may also have a circular planar shape.

In some embodiments, the second inclined portion N2 may include a first sub-inclined portion N2_1 and a second sub-inclined portion N2_2. The first sub-inclined portion N2_1 may be a portion in which the upper surface of the pixel electrode 131 extends in a diagonal direction defined by a direction opposite to the first direction DR1 and the third direction DR3 in cross section, and the second sub-inclined portion N2_2 may be a portion in which the upper surface of the pixel electrode 131 extends in a diagonal direction defined by the first direction DR1 and the third direction DR3 in cross section. The first sub-inclined portion N2_1 and the second sub-inclined portion N2_2 may directly intersect and be connected to each other at a third point P3.

The third flat portion M3 may be formed to surround the periphery of the second inclined portion N2. The third flat portion M3 may be an area where the upper surface of the pixel electrode 131 is flat, or the inclination angle of the upper surface of the pixel electrode 131 is less than the first angle. That is, the third flat portion M3 may be an area where the upper surface of the pixel electrode 131 is flat or nearly flat. Here, the inclination angle of the upper surface (e.g., a second upper surface portion) of the pixel electrode 131 in the third flat portion M3 refers to an acute angle among the angles defined by an extension line parallel to the upper surface (e.g., the second upper surface portion) of the pixel electrode 131 disposed in the third flat portion M3 and the extension line parallel to the upper surface of the substrate 110.

Since the third flat portion M3 is an area where the upper surface of the pixel electrode 131 is flat or nearly flat, it may be an area where light generated from the light-emitting layer 132 is emitted toward the front.

The planar shape of the third flat portion M3 may be a round ring or round loop shape with a hollow center, like a donut.

The display device 10 in the illustrated embodiment may secure a process margin for forming the second inclined portion N2 and emission areas EA1 through EA3 by including the third flat portion M3. In an embodiment, the position and width of an emission area EA1, EA2 or EA3 and the position and width of the second inclined portion N2 may be determined based on an approximate center of an opening of a pixel defining layer 135, for example. At this time, even when a reference point deviates from the approximate center of the opening of the pixel defining layer 135 by a selected distance, a safety process margin may be secured by the third flat portion M3.

In addition, the display device 10 in the illustrated embodiment may minimize a decrease in front luminance by including the third flat portion M3, even when it includes the second inclined portion N2 to increase side luminance.

In the third flat portion M3, an upper surface of an under-anode insulating layer 129 may be flat, or an inclination angle of the upper surface of the under-anode insulating layer 129 may be less than the first angle. In an embodiment, the first angle may be about 3 degrees, for example. When the slope of the upper surface of the under-anode insulating layer 129 is less than about 3 degrees, the upper surface of the under-anode insulating layer 129 may be considered to be substantially flat without a slope. Here, the inclination angle of the upper surface of the under-anode insulating layer 129 in the third flat portion M3 refers to an acute angle among the angles defined by an extension line parallel to the upper surface of the under-anode insulating layer 129 disposed in the third flat portion M3 and the extension line parallel to the upper surface of the substrate 110.

In the second inclined portion N2, the inclination angle of the upper surface of the under-anode insulating layer 129 may be equal to or greater than the first angle. Here, the inclination angle of the upper surface of the under-anode insulating layer 129 in the second inclined portion N2 refers to an acute angle among the angles defined by an extension line parallel to the upper surface of the under-anode insulating layer 129 disposed in the second inclined portion N2 and the extension line parallel to the upper surface of the substrate 110.

In the specification, a boundary between the second inclined portion N2 and the third flat portion M3 is based on the degree of slope of the upper surface of the pixel electrode 131. In an embodiment, the third flat portion M3 may be an area where the upper surface of the pixel electrode 131 is flat, and the second inclined portion N2 may be an area where the upper surface of the pixel electrode 131 is inclined, for example.

Since the shape of the pixel electrode 131 corresponds to the shape of the upper surface of the under-anode insulating layer 129, the boundary between the second inclined portion N2 and the third flat portion M3 may also be based on the degree of slope of the upper surface of the under-anode insulating layer 129. In an embodiment, the third flat portion M3 may be an area where the upper surface of the under-anode insulating layer 129 is flat, and the second inclined portion N2 may be an area where the upper surface of the under-anode insulating layer 129 is inclined, for example.

The under-anode insulating layer 129 may include a first under-anode insulating layer 1291.

The first under-anode insulating layer 1291 may be disposed on a second planarization layer 128. The first under-anode insulating layer 1291 may include the first groove H2. The first groove H2 may be disposed approximately at the center of the first emission area EA1. The first groove H2 may overlap the second inclined portion N2.

The first under-anode insulating layer 1291 may include a second inclined surface Q2. The second inclined surface Q2 may be disposed within the first groove H2. The second inclined surface Q2 may form an inner surface of the first groove H2. The second inclined portion N2 may have a selected slope along the shape of the second inclined surface Q2. In an embodiment, a portion of a lower surface of the pixel electrode 131 corresponding to the first groove H2 may have a width h2.

The shapes of the pixel electrode 131, the light-emitting layer 132, and a common electrode 133 may follow the shape of the upper surface of the under-anode insulating layer 129. Therefore, the pixel electrode 131, the light-emitting layer 132, and the common electrode 133 may be flat in the third flat portion M3 and may have a selected slope in the second inclined portion N2.

When an intersection of the first and second sub-inclined portions N2_1 and N2_2 of the second inclined portion N2 is defined as the third point P3 and when an intersection of a flat surface of the pixel electrode 131 disposed in the third flat portion M3 and an inclined surface of the pixel electrode 131 disposed in the second inclined portion N2 is defined as a fourth point P4, a line connecting the third point P3 and the fourth point P4 may be defined as a second inclined line n2. An imaginary extension line extending parallel to the upper surface of the substrate 110 in a direction overlapping the second inclined line n2 from the third point P3 may be defined as a second extension line m2.

In the specification, the second extension line m2, the second inclined line n2, the third point P3, and the fourth point P4 are defined based on the upper surface of the pixel electrode 131. However, since the shape of the upper surface of the pixel electrode 131 may correspond to that of the upper surface of the under-anode insulating layer 129, the second extension line m2, the second inclined line n2, the third point P3, and the fourth point P4 may also be defined based on the upper surface of the under-anode insulating layer 129.

In some embodiments, a second inclination angle θ2 formed by the second extension line m2 and the second inclined line n2 may be about 20 degrees to 35 degrees. When the second extension line m2 and the second inclined line n2 have the second inclination angle θ2, light emitted from the second inclined portion N2 may travel toward the side of the display device 10. Therefore, the luminance and chrominance of a display panel 100 at each viewing angle may be adjusted according to the second inclination angle θ2.

In addition, when the second inclination angle θ2 is less than 20 degrees, the upper surface of the pixel electrode 131 is almost parallel to the direction of an upper surface of the display device 10. When light emitted from the light-emitting layer 132 is refracted as it passes through a member such as a sealing layer 140, light having a long wavelength among white light emitted from the display device 10 travels in the third direction DR3, and light having a short wavelength among the white light travels in a direction intersecting the third direction DR3 due to a difference in refractive index according to the wavelength of light. Accordingly, when a white image of the display device 10 is viewed from the side of the display device 10, it looks somewhat blue compared to when the white image of the display device 10 is viewed from the front of the display device 10.

When the second inclination angle θ2 is 20 degrees or more, a long wavelength portion of light emitted from the second inclined portion N2 travels in the direction intersecting the third direction DR3. Accordingly, the phenomenon in which the white image of the display device 10 looks somewhat blue when viewed from the side may be reduced.

In addition, when a color filter layer 160 is disposed on an element layer 130, when the second inclination angle θ2 is 20 degrees or more, rainbow mura caused by diffraction of light in the color filter layer 160 may be minimized.

When the second inclination angle θ2 exceeds 35 degrees, a light trapping phenomenon in which light is trapped between the pixel electrode 131 and the common electrode 133 without being emitted may occur. In this case, since generated light is not emitted, both the luminance at the front and the luminance at the side of the display device may decrease. Accordingly, in the disclosure, the second inclination angle θ2 may be 20 degrees to 35 degrees, thereby minimizing a decrease in front efficiency and minimizing the occurrence of mura while improving luminance and chrominance at each viewing angle when observed from the side.

A fourth thickness t4 which is a maximum thickness of the first under-anode insulating layer 1291 and a fifth thickness t5 which is a minimum thickness of the first under-anode insulating layer 1291 may be set such that the second inclination angle θ2 is within the above range. The fourth thickness t4 may refer to the thickness of the first under-anode insulating layer 1291 in a portion overlapping the third flat portion M3, and the fifth thickness t5 may refer to the thickness of the first under-anode insulating layer 1291 in a portion overlapping the third point P3. In an embodiment, the fourth thickness t4 may be about 2 µm or more, and the fifth thickness t5 may be about 1 µm or less, for example.

In some embodiments, a second distance t6, which is a distance between an under-anode conductive pattern ESD and the pixel electrode 131, may be about 2 µm or more. The second distance t6 refers to a distance between the pixel electrode 131 in the portion overlapping the third point P3 and the under-anode conductive pattern ESD in the third direction DR3. In an embodiment, the second distance t6 may refer to a distance between a lower surface of the pixel electrode 131 in the portion overlapping the third point P3 and an upper surface of the under-anode conductive pattern ESD in the third direction DR3, for example. When the second distance t6 is about 2 µm or more, electric field interference and optical interference may be reduced, thereby minimizing the occurrence of mura at relatively low luminance and relatively low grayscale levels.

In some embodiments, the first under-anode insulating layer 1291 may include an inorganic insulating layer. In an embodiment, the first under-anode insulating layer 1291 may include at least one of silicon nitride (SiNₓ), silicon oxide (SiOₓ), silicon nitride oxide (SiON), titanium oxide (TiOₓ), and aluminum oxide (AlOₓ), for example.

In the display device 10 in the illustrated embodiment, since the first under-anode insulating layer 1291 includes an inorganic insulating layer, it may be relatively easy to form the second inclination angle θ2 to a predetermined level or greater.

In an embodiment, when the first under-anode insulating layer 1291 includes an organic insulating layer, it has fluidity before being cured, for example. Therefore, an inclination angle of an inclined surface of the first under-anode insulating layer 1291 after being cured may be relatively small. Hence, when the first under-anode insulating layer 1291 includes an organic insulating layer, it must be formed thicker in order to realize a desired inclination angle. When the organic insulating layer is formed thick, the amount of outgas generated during the formation of the organic layer may increase, thus affecting the reliability of the display device 10.

When the first under-anode insulating layer 1291 includes an inorganic insulating layer, its shape may be easily controlled through a process such as dry etching. Therefore, the inclination angle of the inclined surface of the first under-anode insulating layer 1291 may be easily adjusted according to an etching method. Hence, when the first under-anode insulating layer 1291 includes an inorganic insulating layer, a minimum thickness for realizing the desired inclination angle is smaller, and the reliability problem due to outgas may also be overcome.

In the display device 10 in the illustrated embodiment, light may be emitted from both a flat portion and an inclined portion of the light-emitting layer 132. Accordingly, when the display device 10 is observed from the front, a decrease in front efficiency may be minimized because a long wavelength emitted from the third flat portion M3 and a short wavelength emitted from the second inclined portion N2 are mixed. In addition, when the display device 10 is observed from the side, the phenomenon of color distortion and luminance reduction experienced when observed from the side compared to when observed from the front may be improved because a short wavelength emitted from the third flat portion M3, a long wavelength emitted from the second inclined portion N2 on one side, and a long wavelength emitted from the second inclined portion N2 on an opposite side are mixed.

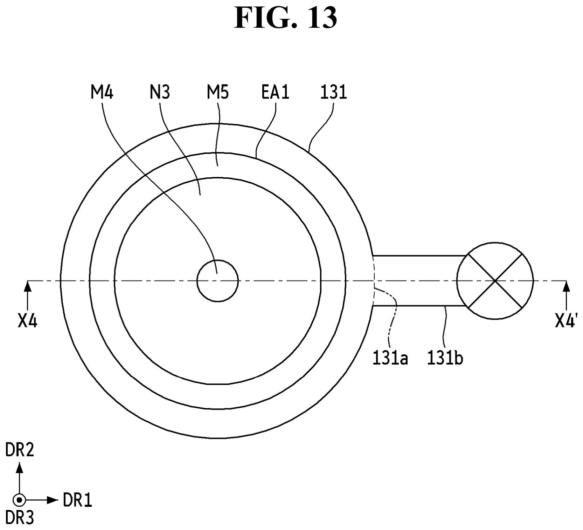

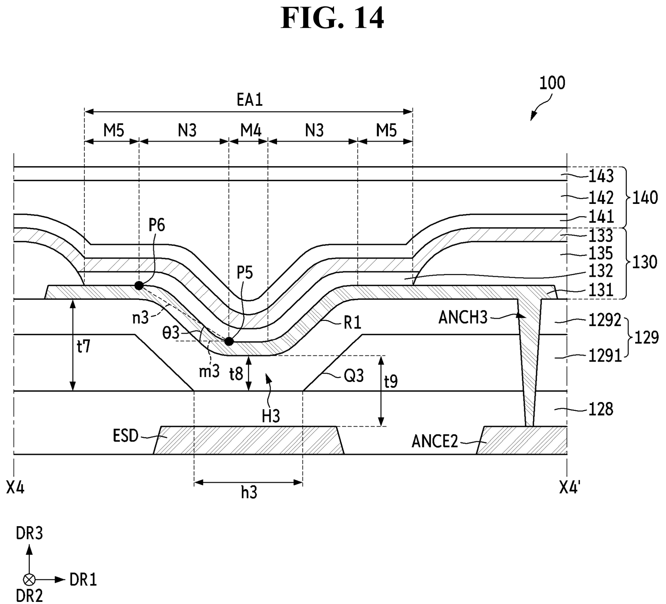

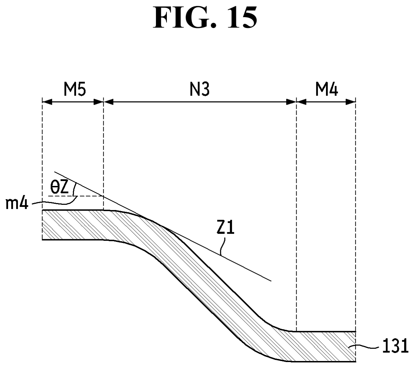

FIG. 13 is an enlarged plan view of an embodiment of a pixel electrode 131 of a first emission area EA1 of a display device 10. FIG. 14 is a cross-sectional view taken along line X4-X4' of FIG. 13. FIG. 15 is a schematic diagram for explaining a method of defining the slope of a third inclined portion N3.

Referring to FIGS. 13 through 15, the display device 10 in the illustrated embodiment is different from the display device 10 in the embodiments described above with reference to FIGS. 6 and 11, etc., in the arrangement and shape of a first under-anode insulating layer 1291 and a second under-anode insulating layer 1292.

More specifically, the first emission area EA1 may include a fourth flat portion M4, the third inclined portion N3, and a fifth flat portion M5.

The fourth flat portion M4 may be disposed at the center of the first emission area EA1. The fourth flat portion M4 may be an area where an upper surface of the pixel electrode 131 is flat, or an inclination angle of the upper surface of the pixel electrode 131 is less than a first angle. In some embodiments, the first angle may be about 3 degrees. That is, the fourth flat portion M4 may be an area where the upper surface of the pixel electrode 131 is flat or nearly flat. Here, the inclination angle of the upper surface (e.g., a first upper surface portion) of the pixel electrode 131 in the fourth flat portion M4 refers to an acute angle among the angles defined by an extension line parallel to the upper surface (e.g., the first upper surface portion) of the pixel electrode 131 disposed in the fourth flat portion M4 and an extension line parallel to an upper surface of a substrate 110.

Since the fourth flat portion M4 is an area where the upper surface of the pixel electrode 131 is flat or nearly flat, it may be an area where light generated from a light-emitting layer 132 is emitted toward the front.

The planar shape of the fourth flat portion M4 may follow the planar shape of the first emission area EA1. When the first emission area EA1 has a circular planar shape as in FIG. 13, the fourth flat portion M4 may also have a circular planar shape.

The third inclined portion N3 may be formed to surround the periphery of the fourth flat portion M4. The third inclined portion N3 may be disposed between the fourth flat portion M4 and the fifth flat portion M5.

The third inclined portion N3 may be an area where the inclination angle of the pixel electrode 131 is equal to or greater than the first angle. Here, the inclination angle of the upper surface (e.g., a third upper surface portion) of the pixel electrode 131 in the third inclined portion N3 refers to an acute angle among the angles that tangent lines touching the upper surface (e.g., the third upper surface portion) of the pixel electrode 131 disposed in the third inclined portion N3 form with the extension line parallel to the upper surface of the substrate 110.

In an embodiment, as illustrated in FIG. 15, a first tangent line Z1 touching a point on the upper surface (e.g., the third upper surface portion) of the pixel electrode 131 disposed in the third inclined portion N3 may be defined, for example. The extension line parallel to the upper surface of the substrate 110 may be defined as a fourth extension line m4. An acute angle among the angles defined by the first tangent line Z1 and the fourth extension line m4 may be defined as a tangent angle θZ. The tangent angle θZ may be equal to or greater than the first angle in the third inclined portion N3. Tangent angles θZ that not only the first tangent line Z1 but also tangent lines touching all points on the upper surface of the pixel electrode 131 disposed in the third inclined portion N3 form with the fourth extension line m4 may be equal to or greater than the first angle.

In the embodiments described above with reference to FIGS. 8 and 12, etc. and in the illustrated embodiment described with reference to FIG. 14, etc., the inclination angle of the upper surface of the pixel electrode 131 in the first through fifth flat portions M1 through M5, the first inclined portion N1, and the second inclined portion N2 is defined as an acute angle among the angles defined by the extension line parallel to the upper surface of the pixel electrode 131 and the extension line parallel to the upper surface of the substrate 110. However, the disclosure is not limited thereto, and the inclination angle of the upper surface of the pixel electrode 131 may also be defined as in FIG. 15.

In an embodiment, the inclination angle of the upper surface of the pixel electrode 131 in the first through fifth flat portions M1 through M5, the first inclined portion N1, and the second inclined portion N2 may refer to an acute angle among the angles that tangent lines touching the upper surface of the pixel electrode 131 disposed in the first through fifth flat portions M1 through M5, the first inclined portion N1 and the second inclined portion N2 form with the extension line parallel to the upper surface of the substrate 110, for example.

In the case of the first through fifth flat portions M1 through M5, the first inclined portion N1, and the second inclined portion N2, the slope of the upper surface of the pixel electrode 131 is generally constant. Therefore, tangent lines touching all points on the upper surface of the pixel electrode 131 may lie substantially on the same line as the upper surface of the pixel electrode 131. Therefore, the slope of the upper surface of the pixel electrode 131 in the first through fifth flat portions M1 through M5, the first inclined portion N1, and the second inclined portion N2 may be defined as the slope of the upper surface of the pixel electrode 131 itself or may be defined as the slope of the tangent lines touching the upper surface of the pixel electrode 131.

Since a slope of the first angle or greater is formed in the pixel electrode 131 in the third inclined portion N3, the third inclined portion N3 may be an area where light generated from the light-emitting layer 132 is emitted toward the side of the display device 10. The planar shape of the third inclined portion N3 may be a round ring or round loop shape with a hollow center, like a donut.

The fifth flat portion M5 may be formed to surround the periphery of the third inclined portion N3. The fifth flat portion M5 may be an area where the upper surface of the pixel electrode 131 is flat, or the inclination angle of the upper surface of the pixel electrode 131 is less than the first angle. That is, the fifth flat portion M5 may be an area where the upper surface of the pixel electrode 131 is flat or nearly flat. Here, the inclination angle of the upper surface (e.g., a second upper surface portion) of the pixel electrode 131 in the fifth flat portion M5 refers to an acute angle among the angles defined by an extension line parallel to the upper surface (e.g., the second upper surface portion) of the pixel electrode 131 disposed in the fifth flat portion M5 and the extension line parallel to the upper surface of the substrate 110.

Since the fifth flat portion M5 is an area where the upper surface of the pixel electrode 131 is flat or nearly flat, it may be an area where light generated from the light-emitting layer 132 is emitted toward the front.

The planar shape of the fifth flat portion M5 may be a round ring or round loop shape with a hollow center, like a donut.

The display device 10 in the illustrated embodiment may secure a process margin for forming the third inclined portion N3 and emission areas EA1 through EA3 by including the fifth flat portion M5. In an embodiment, the position and width of an emission area EA1, EA2 or EA3 and the position and width of the third inclined portion N3 may be determined based on an approximate center of an opening of a pixel defining layer 135, for example. At this time, even when a reference point deviates from the approximate center of the opening of the pixel defining layer 135 by a selected distance, a safety process margin may be secured by the fifth flat portion M5.

In addition, the display device 10 in the illustrated embodiment may minimize a decrease in front luminance by including the fifth flat portion M5, even when it includes the third inclined portion N3 to increase side luminance.

The fourth flat portion M4 and the fifth flat portion M5 may be spaced apart from each other, and the third inclined portion N3 may be disposed between the fourth flat portion M4 and the fifth flat portion M5.

In the fourth flat portion M4 and the fifth flat portion M5, an upper surface of an under-anode insulating layer 129 may be flat, or an inclination angle of the upper surface of the under-anode insulating layer 129 may be less than the first angle. In an embodiment, the first angle may be about 3 degrees, for example. When the slope of the upper surface of the under-anode insulating layer 129 is less than about 3 degrees, the upper surface of the under-anode insulating layer 129 may be considered to be substantially flat without a slope. Here, the inclination angle of the upper surface of the under-anode insulating layer 129 in the fourth flat portion M4 or the fifth flat portion M5 refers to an acute angle among the angles defined by an extension line parallel to the upper surface of the under-anode insulating layer 129 disposed in the fourth flat portion M4 or the fifth flat portion M5 and the extension line parallel to the upper surface of the substrate 110.

In the third inclined portion N3, the inclination angle of the upper surface of the under-anode insulating layer 129 may be equal to or greater than the first angle. Here, the inclination angle of the upper surface of the under-anode insulating layer 129 in the third inclined portion N3 refers to an acute angle among the angles that tangent lines touching the upper surface of the under-anode insulating layer 129 disposed in the third inclined portion N3 form with the extension line parallel to the upper surface of the substrate 110.

In the specification, boundaries between the fourth flat portion M4, the third inclined portion N3, and the fifth flat portion M5 are based on the degree of slope of the upper surface of the pixel electrode 131. In an embodiment, the fourth flat portion M4 and the fifth flat portion M5 may be areas where the upper surface of the pixel electrode 131 is flat, and the third inclined portion N3 may be an area where the upper surface of the pixel electrode 131 is inclined, for example.

Since the shape of the pixel electrode 131 corresponds to the shape of the upper surface of the under-anode insulating layer 129, the boundaries between the fourth flat portion M4, the third inclined portion N3, and the fifth flat portion M5 may also be based on the degree of slope of the upper surface of the under-anode insulating layer 129. In an embodiment, the fourth flat portion M4 and the fifth flat portion M5 may be areas where the upper surface of the under-anode insulating layer 129 is flat, and the third inclined portion N3 may be an area where the upper surface of the under-anode insulating layer 129 is inclined, for example.

The under-anode insulating layer 129 may include the first under-anode insulating layer 1291 and the second under-anode insulating layer 1292.

The first under-anode insulating layer 1291 may be disposed on a second planarization layer 128. The first under-anode insulating layer 1291 may define a second hole H3. The second hole H3 may be defined approximately at the center of the first emission area EA1. A central portion of the second hole H3 may overlap the fourth flat portion M4, and an edge portion of the second hole H3 may overlap the third inclined portion N3.

The first under-anode insulating layer 1291 may include a third inclined surface Q3. The third inclined surface Q3 may be disposed on a side of the second hole H3. The third inclined surface Q3 may surround the second hole H3 in a plan view. The third inclined surface Q3 may be an inner surface surrounding the second hole H3 in a plan view. The third inclined portion N3 may have a selected slope along the shape of the third inclined surface Q3.

The second under-anode insulating layer 1292 may be disposed on the first under-anode insulating layer 1291. The second under-anode insulating layer 1292 may be disposed on the second planarization layer 128 exposed in the second hole H3. That is, the second under-anode insulating layer 1292 may cover an upper surface of the second planarization layer 128 exposed in the second hole H3, the third inclined surface Q3 of the first under-anode insulating layer 1291, and an upper surface of the first under-anode insulating layer 1291.

The shape of an upper surface of the second under-anode insulating layer 1292 may follow the shape of the upper surface of the second planarization layer 128 exposed in the second hole H3, the shape of the third inclined surface Q3 of the first under-anode insulating layer 1291, and the shape of the upper surface of the first under-anode insulating layer 1291. In an embodiment, of the upper surface of the second under-anode insulating layer 1292, a portion overlapping the central portion of the second hole H3 (e.g., a portion overlapping the fourth flat portion M4) may be flat or have a slope of less than the first angle, for example. Of the upper surface of the second under-anode insulating layer 1292, a portion overlapping the edge portion of the second hole H3 and a portion overlapping the third inclined surface Q3 (e.g., a portion overlapping the third inclined portion N3) may have a selected slope or have a slope of the first angle or greater. Of the upper surface of the second under-anode insulating layer 1292, a portion overlapping the upper surface of the first under-anode insulating layer 1291 (e.g., a portion overlapping the fifth flat portion M5) may be flat or have a slope of less than the first angle. In an embodiment, a portion of an upper surface of the second planarization layer 128 corresponding to the second hole H3 may have a width h3.

The second under-anode insulating layer 1292 may include an organic layer such as acryl resin, epoxy resin, phenolic resin, polyamide resin, or polyimide resin.

The second under-anode insulating layer 1292 may include a fourth inclined surface R1. The fourth inclined surface R1 refers to the portion overlapping the edge portion of the second hole H3 and the portion overlapping the third inclined surface Q3. In an embodiment, the fourth inclined surface R1 refers to the portion overlapping the third inclined surface N3, for example.

The fourth inclined surface R1 may include a curved surface. Since the second under-anode insulating layer 1292 includes an organic material, it has fluidity before being cured. Therefore, the fourth inclined surface R1 may include a curved surface having a selected curvature between the fourth flat portion M4 and the fifth flat portion M5.

In addition, since the second under-anode insulating layer 1292 including an organic material has fluidity before being cured, an eighth thickness t8 of the second under-anode insulating layer 1292 may have a maximum value in the central portion of the second hole H3.

The shapes of the pixel electrode 131, the light-emitting layer 132, and a common electrode 133 may follow the shape of the upper surface of the under-anode insulating layer 129 (e.g., the shape of the upper surface of the second under-anode insulating layer 1292). Therefore, the pixel electrode 131, the light-emitting layer 132, and the common electrode 133 may be flat in the fourth flat portion M4 and the fifth flat portion M5 and may have a selected slope in the third inclined portion N3.

When an intersection of a flat surface of the second under-anode insulating layer 1292 disposed in the fourth flat portion M4 and an inclined surface of the second under-anode insulating layer 1292 disposed in the third inclined portion N3 is defined as a fifth point P5 and when an intersection of the inclined surface of the second under-anode insulating layer 1292 disposed in the third inclined portion N3 and a flat surface of the second under-anode insulating layer 1292 disposed in the fifth flat portion M5 is defined as a sixth point P6, a line connecting the fifth point P5 and the sixth point P6 may be defined as a third inclined line n3. An imaginary extension line extending parallel to the upper surface of the substrate 110 from the fifth point P5 toward an opposite side from the fourth flat portion M4 may be defined as a third extension line m3.

In the specification, the third extension line m3, the third inclined line n3, the fifth point P5, and the sixth point P6 are defined based on the upper surface of the second under-anode insulating layer 1292. However, since the shape of the upper surface of the pixel electrode 131 may correspond to that of the upper surface of the under-anode insulating layer 129, the third extension line m3, the third inclined line n3, the fifth point P5, and the sixth point P6 may also be defined based on the upper surface of the pixel electrode 131.

In some embodiments, a third inclination angle θ3 formed by the third extension line m3 and the third inclined line n3 may be about 20 degrees to 35 degrees. When the third extension line m3 and the third inclined line n3 have the third inclination angle 03, light emitted from the third inclined portion N3 may travel toward the side of the display device 10. Therefore, the luminance and chrominance of a display panel 100 at each viewing angle may be adjusted according to the third inclination angle θ3.

When the third inclination angle θ3 is less than 20 degrees, the luminance may decrease when an image of the display device 10 is viewed from the side of the display device 10 compared to when the image of the display device 10 is viewed from the front of the display device 10.

In addition, when the third inclination angle θ3 is less than 20 degrees, the upper surface of the pixel electrode 131 is almost parallel to the direction of an upper surface of the display device 10. When light emitted from the light-emitting layer 132 is refracted as it passes through a member such as a sealing layer 140, light having a long wavelength among white light emitted from the display device 10 travels in the third direction DR3, and light having a short wavelength among the white light travels in a direction intersecting the third direction DR3 due to a difference in refractive index according to the wavelength of light. Accordingly, when a white image of the display device 10 is viewed from the side of the display device 10, it looks somewhat blue compared to when the white image of the display device 10 is viewed from the front of the display device 10.

When the third inclination angle θ3 is 20 degrees or more, a long wavelength portion of light emitted from the third inclined portion N3 travels in the direction intersecting the third direction DR3. Accordingly, the phenomenon in which the white image of the display device 10 looks somewhat blue when viewed from the side may be reduced.

In addition, when a color filter layer 160 is disposed on an element layer 130, when the third inclination angle θ3 is 20 degrees or more, rainbow mura caused by diffraction of light in the color filter layer 160 may be minimized.

When the third inclination angle θ3 exceeds 35 degrees, a light trapping phenomenon in which light is trapped between the pixel electrode 131 and the common electrode 133 without being emitted may occur. In this case, since generated light is not emitted, both the luminance at the front and the luminance at the side of the display device may decrease. Accordingly, in the disclosure, the third inclination angle θ3 may be 20 degrees to 35 degrees, thereby minimizing a decrease in front efficiency and minimizing the occurrence of mura while improving luminance and chrominance at each viewing angle when observed from the side.

A seventh thickness t7 which is a maximum thickness of the under-anode insulating layer 129 and the eighth thickness t8 which is a maximum thickness of the second under-anode insulating layer 1292 may be set such that the third inclination angle θ3 is within the above range. The seventh thickness t7 may refer to the sum of a thickness of the first under-anode insulating layer 1291 and a thickness of the second under-anode insulating layer 1292 in the portion overlapping the fifth flat portion M5, and the eighth thickness t8 may refer to the thickness of the second under-anode insulating layer 1292 in the portion overlapping the fourth flat portion M4. In an embodiment, the seventh thickness t7 may be about 2 µm or more, and the eighth thickness t8 may be about 1 µm or less, for example.

In some embodiments, a third distance t9, which is a distance between an under-anode conductive pattern ESD and the pixel electrode 131, may be about 2 µm or more. The third distance t9 refers to a distance between the pixel electrode 131 disposed in the fourth flat portion M4 and the under-anode conductive pattern ESD in the third direction DR3. In an embodiment, the third distance t9 may refer to a distance between a lower surface of the pixel electrode 131 disposed in the fourth flat portion M4 and an upper surface of the under-anode conductive pattern ESD in the third direction DR3, for example. When the third distance t9 is about 2 µm or more, electric field interference and optical interference may be reduced, thereby minimizing the occurrence of mura at relatively low luminance and relatively low grayscale levels.

In some embodiments, the first under-anode insulating layer 1291 may include an inorganic insulating layer. In an embodiment, the first under-anode insulating layer 1291 may include at least one of silicon nitride (SiNₓ), silicon oxide (SiOₓ), silicon nitride oxide (SiON), titanium oxide (TiOₓ), and aluminum oxide (AlOₓ), for example.

In the display device 10 in the illustrated embodiment, since the first under-anode insulating layer 1291 includes an inorganic insulating layer, it may be relatively easy to form the third inclination angle θ3 to a predetermined level or greater.

In an embodiment, when the first under-anode insulating layer 1291 includes an organic insulating layer, it has fluidity before being cured, for example. Therefore, an inclination angle of an inclined surface of the first under-anode insulating layer 1291 after being cured may be relatively small. Hence, when the first under-anode insulating layer 1291 includes an organic insulating layer, it must be formed thicker in order to realize a desired inclination angle. When the organic insulating layer is formed thick, the amount of outgas generated during the formation of the organic layer may increase, thus affecting the reliability of the display device 10.

When the first under-anode insulating layer 1291 includes an inorganic insulating layer, its shape may be easily controlled through a process such as dry etching. Therefore, the inclination angle of the inclined surface of the first under-anode insulating layer 1291 may be easily adjusted according to an etching method. Hence, when the first under-anode insulating layer 1291 includes an inorganic insulating layer, a minimum thickness for realizing the desired inclination angle is smaller, and the reliability problem due to outgas may also be overcome.

The second under-anode insulating layer 1292 including an organic material may function as a capping layer for protecting the first under-anode insulating layer 1291 by completely covering the first under-anode insulating layer 1291. Accordingly, the durability of the display device 10 may be improved.

In the display device 10 in the illustrated embodiment, light may be emitted from both a flat portion and an inclined portion of the light-emitting layer 132. Accordingly, when the display device 10 is observed from the front, a decrease in front efficiency may be minimized because a long wavelength emitted from the fourth flat portion M4 and the fifth flat portion M5 and a short wavelength emitted from the third inclined portion N3 are mixed. In addition, when the display device 10 is observed from the side, the phenomenon of color distortion and luminance reduction experienced when observed from the side compared to when observed from the front may be improved because a short wavelength emitted from the fourth flat portion M4 and the fifth flat portion M5, a long wavelength emitted from the third inclined portion N3 on one side, and a long wavelength emitted from the third inclined portion N2 on an opposite side are mixed.

In concluding the detailed description, those skilled in the art will appreciate that many variations and modifications may be made to the preferred embodiments without substantially departing from the principles of the disclosure as defined by the appended claims. Therefore, the disclosed preferred embodiments of the disclosure are used in a generic and descriptive sense only and not for purposes of limitation.

## Claims

1. A display device (10) comprising:
a substrate (110);
a transistor (TR) disposed on a surface of the substrate (110);
an under-anode insulating layer (129) disposed on the transistor (TR) and comprising a first portion (131a) and a second portion (131b) having different thicknesses (t) from each other and a third portion connecting the first portion (131a) and the second portion (131b), the under-anode insulating layer (129) comprising:
a first under-anode insulating layer (1291) comprising an inorganic material and defining a first hole (H1) in the first portion (131a); and
a second under-anode insulating layer (1292) comprising an organic material and defining or including at least a portion within the first hole (H1) and corresponding to or contacting the first portion (131a);
a pixel electrode (131) disposed on the first portion (131a), the second portion (131b), and the third portion;
a pixel defining layer (135) disposed on the pixel electrode (131) and the under-anode insulating layer (129) and comprising an opening which overlaps the first portion (131a), the second portion (131b) and the third portion;
a light-emitting layer (132) disposed on the pixel electrode (131); and
a common electrode (133) disposed on the light-emitting layer (132) and the pixel defining layer (135).

2. The display device (10) of claim 1, wherein the first portion (131a) and the second portion (131b) are flat portions (M), and the third portion is an inclined portion (N).

3. The display device (10) of claim 1 or 2, wherein an upper surface of the pixel electrode (131) comprises a first upper surface portion overlapping the first portion (131a), a second upper surface portion overlapping the second portion (131b) and a third upper surface portion overlapping the third portion, angles between tangent lines (Z) touching the third upper surface portion and the surface of the substrate (110) are equal to or greater than a first angle, and angles between tangent lines (Z) touching the first upper surface portion and the surface of the substrate (110) and angles between tangent lines (Z) touching the second upper surface portion and the surface of the substrate (110) are less than the first angle.

4. The display device (10) of claim 3, wherein when an intersection of the first upper surface portion and the third upper surface portion is defined as a first point (P1), an intersection of the second upper surface portion and the third upper surface portion is defined as a second point (P2), an imaginary extension line extending parallel to the surface of the substrate (110) from the first point (P1) toward an opposite side from the first upper surface portion is defined as a first extension line (m1), and a line connecting the first point (P1) and the second point (P2) is defined as a first inclined line (n1), a first inclination angle (θ1) defined by the first inclined line (n1) and the first extension line (m1) is 20 degrees or more.

5. The display device (10) of any one of claims 1 to 4,
wherein the first under-anode insulating layer (1291) contacts the pixel electrode (131) in the second portion (131b) and the third portion, and the second under-anode insulating layer (1292) contacts the pixel electrode (131) in the first portion (131a); and/or
wherein the second under-anode insulating layer (1292) is disposed only within the first hole (H1).

6. The display device (10) of any one of claims 1 to 5, wherein the first under-anode insulating layer (1291) further comprises a first inclined surface (Q1) overlapping the third portion and an upper surface connected to the first inclined surface (Q1), an upper surface of the second under-anode insulating layer (1292) directly contacts the pixel electrode (131) in the first portion (131a), the second portion (131b) and the third portion, and a lower surface of the second under-anode insulating layer (1292) directly contacts the first inclined surface (Q1) and the upper surface of the first under-anode insulating layer (1291).

7. The display device (10) of claim 6,
wherein the upper surface of the second under-anode insulating layer (1292) in the second portion (131b) comprises a curved surface; and/or
wherein the thickness (t) of the second under-anode insulating layer (1292) in the first portion (131a) is 1 micrometer or less.

8. A display device (10) comprising:
a substrate (110);
a transistor (TR) disposed on a surface of the substrate (110);
an under-anode insulating layer (129) disposed on the transistor (TR) and defining a groove (H2), the under-anode insulating layer (129) comprising a first portion (131a) overlapping the groove (H2), and a second portion (131b) having a different thickness (t) from a thickness (t) of the first portion (131a);
a pixel electrode (131) disposed on the first portion (131a) and the second portion (131b);
a pixel defining layer (135) disposed on the pixel electrode (131) and the under-anode insulating layer (129) and comprising an opening which overlaps the first portion (131a) and the second portion (131b);
a light-emitting layer (132) disposed on the pixel electrode (131); and
a common electrode (133) disposed on the light-emitting layer (132) and the pixel defining layer (135),
wherein the under-anode insulating layer (129) comprises an inorganic material.

9. The display device (10) of claim 8, wherein the first portion (131a) is an inclined portion (N), and the second portion (131b) is a flat portion (M).

10. The display device (10) of claim 8 or 9, wherein an upper surface of the pixel electrode (131) comprises a first upper surface portion overlapping the first portion (131a) and a second upper surface portion overlapping the second portion (131b), angles between tangent lines touching the first upper surface portion and the surface of the substrate (110) are equal to or greater than a first angle, and angles between tangent lines (Z) touching the second upper surface portion and the surface of the substrate (110) are less than the first angle.

11. The display device (10) of claim 10, wherein the first upper surface portion comprises a first sub-portion and a second sub-portion directly connected to each other and extending in different directions in a cross section taken in a thickness direction of the substrate (110), and when an intersection of the first sub-portion and the second sub-portion is defined as a first point (P1), an intersection of the first upper surface portion and the second upper surface portion is defined as a second point (P2), a line connecting the first point (P1) and the second point (P2) is defined as a first inclined line (n1), and an imaginary extension line extending parallel to the surface of the substrate (110) in a direction overlapping the first inclined line (n1) from the first point (P1) is defined as a first extension line (m1), a first inclination angle (θ1) defined by the first inclined line (n1) and the first extension line (m1) is 20 degrees or more.

12. The display device (10) of claim 11,
wherein in the thickness direction of the substrate (110), a thickness (t) of the under-anode insulating layer (129) in an area overlapping the first point (P1) is 1 micrometer or less; and/or
wherein the thickness (t) of the under-anode insulating layer (129) in the second portion (131b) is 2 micrometers or more.

13. The display device (10) of any one of the preceding claims, further comprising a source-drain conductive layer (SDCDL) disposed between the transistor (TR) and the under-anode insulating layer (129) and comprising one or more under-anode conductive patterns (ESD), wherein the source-drain conductive layer (SDCDL) comprises a first conductive pattern (ESD) closest to the pixel electrode (131) in a thickness direction of the substrate (110) among the one or more under-anode conductive patterns (ESD), and a distance between the first conductive pattern (ESD) and the pixel electrode (131) is 2 micrometers or more.

14. The display device (10) of any one of the preceding claims, further comprising a color filter layer (160) disposed on the common electrode (133).

15. An electronic device (1) comprising:
a display device (10) of any one of the preceding claims;
a cover window (11) disposed on the display device (10);
a bottom cover (12) disposed under the display device (10); and
a main circuit board (14) disposed between the display device (10) and the bottom cover (12).
